(19) Europäisches Patentamt
European Patent Office
Office européen des brevets

(11) EP 2 732 966 B1

(12) **EUROPEAN PATENT SPECIFICATION**

(45) Date of publication and mention of the grant of the patent:
**02.03.2016 Bulletin 2016/09**

(21) Application number: **12814436.7**

(22) Date of filing: **10.07.2012**

(51) Int Cl.:
***B32B 7/02*** *(2006.01)* ***B32B 33/00*** *(2006.01)*

(86) International application number:
**PCT/JP2012/067586**

(87) International publication number:
**WO 2013/011872 (24.01.2013 Gazette 2013/04)**

(54) **GAS BARRIER FILM AND METHOD FOR PRODUCING SAME**

GASBARRIERENLAMINATFILM UND HERSTELLUNGSVERFAHREN DAFÜR

FILM DE BARRIERE AUX GAZ ET PROCEDE DE FABRICATION DE CELUI-CI

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **15.07.2011 JP 2011156459**

(43) Date of publication of application:
**21.05.2014 Bulletin 2014/21**

(73) Proprietor: **Konica Minolta, Inc.**
**Tokyo 100-7015 (JP)**

(72) Inventor: **HONDA, Makoto**
**Hachioji-shi**
**Tokyo 192-8505 (JP)**

(74) Representative: **Green, Mark Charles**
**Urquhart-Dykes & Lord LLP**
**The Podium**
**1 Eversholt Street**
**London NW1 2DN (GB)**

(56) References cited:
**WO-A1-2008/096617**
**JP-A- 2004 175 094**
**JP-A- 2010 017 991**
**JP-A- 2011 011 424**
**JP-A- 2011 051 220**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 732 966 B1

## Description

### TECHNICAL FIELD

The present invention relates to a gas barrier film having a gas barrier layer and a method for producing the same. More specifically, the invention relates to a gas barrier film mainly in display materials including packages of electric devices, and the like, and plastic substrates of a solar battery, an organic EL element, a liquid crystal, and the like, and a method for producing the same.

### BACKGROUND ART

Conventionally, a gas barrier film in which a thin film made of a metal oxide such as aluminum oxide, magnesium oxide and silicon oxide is formed on a surface of a plastic substrate or a film has been broadly used for the purposes of wrapping of goods that are required to seal various gases such as steam and oxygen and wrapping for preventing deterioration of food, industrial goods, and medical drugs. In addition, a gas barrier film has been also used in a liquid crystal display element, a solar battery, an organic electroluminescence (EL) substrate, and the like other than the wrapping purposes.

As a method of forming such a gas barrier film, a technique of forming a gas barrier layer by the plasma CVD method (Chemical Vapor Deposition: chemical vapor phase growth method, chemical vapor deposition method) and a technique of a surface treatment by applying a coating liquid made of polysilazane as a main component have been known (For example, see Patent Literatures 1 to 3).

In a constitution of a gas barrier film, in general, a gas barrier layer made of an inorganic oxide is formed on a plastic substrate as described above. Since a plastic substrate and an inorganic oxide are largely different in mechanical physical properties and thermal physical properties, when an inorganic oxide layer is directly formed on the plastic substrate, increase of pin holes, cracks in the film surface of the inorganic oxide layer are generated; therefore, a layer with intermediate physical properties of plastic and inorganic oxide is inserted between the plastic substrate and the gas barrier layer to try to improve gas barrier performance of the gas barrier film (for example, Patent Literatures 4 to 6).

The Patent Literature 4 discloses that a so-called hard coat layer is provided using a UV curable resin on a plastic substrate, and besides a C ratio of the SiOC layer is decreased stepwise toward a $SiO_2$ layer that is a gas barrier layer in the CVD method. In the Patent Literature 4, difference in physical properties in a gas barrier layer made of a plastic substrate and an inorganic oxide is alleviated by arranging a layer having an elastic modulus at a measurement by nanoindentation which is increased stepwise and a gas barrier film with a very small water vapor transmission ratio is produced. However, the Patent Literature 4 only prescribes physical properties of the SiOC layer as an elastic modulus and does not describe the other physical properties at all.

Although Patent Literature 5 describes a hardness of an organic layer in a structure of organic and inorganic alternative laminated layers, and the other physical properties are not specifically described.

Patent Literature 6 discloses a technique in which the hardness is increased stepwise toward the surface from a substrate side in a surface in the side of forming a gas barrier layer of a gas barrier film and a layer with the highest hardness is arranged in the top surface, thereby suppressing deterioration of performance of the gas barrier film. However, the Patent Literature 6 only describes the hardness in terms of physical properties, furthermore, a layer with the highest hardness is necessary to the top surf ace layer, and eventually, a layer that is equal to the gas barrier layer or a layer that is more easily broken than the gas barrier layer is arranged. Therefore, bend resistance is deteriorated.

In addition, in recent years, a gas barrier film having high gas barrier performance is desired to be produced at a low cost. Therefore, it has been studied, for example, as in Patent Literatures 2 and 3 that a gas barrier layer is formed in roll-to-roll continuous production under atmospheric pressure or in a coating method with high film formation efficiency.

However, any of these techniques is a film forming method in a vapor deposition system using CVD, has low film formation productivity, and is a technique that requires an environment with a reduced pressure. Furthermore, in a gas barrier film produced in a coating method, studies regarding mechanical physical properties of respective layers have not been reported, and it is a current circumstance that a gas barrier film having a water vapor transmission ratio (WVTR) lower than $1 \times 10^{-2}$ g/m$^2$/day cannot be realized.

A further gas barrier film is known from Patent Literature 7.

Citation List

Patent Literatures

Patent Literature 1: Japanese Patent Laid-Open No. 2008-56967
Patent Literature 2: Japanese Patent Laid-Open No. 2009-255040
Patent Literature 3: US Patent Application Publication No. 2010/166977
Patent Literature 4: US Patent Application Publication No. 2010/003482
Patent Literature 5: US Patent Application Publication No. 2011/064947
Patent Literature 6: Japanese Patent Laid-Open No. 11-158608
Patent Literature 7: Application Publication No. WO 2008/096617 A1

## SUMMARY OF INVENTION

Technical Problem

The present invention was made with the view to the above described problems and an object thereof is to provide a gas barrier film having high gas barrier performance and a method for producing a gas barrier film with continuous productivity.

Solution to Problem

In order to realize at least one of the above described objects, one embodiment of the present invention is described as follows.

1. A gas barrier film, which is obtained by laminating at least one gas barrier layer on a resin substrate, wherein a hardness and an elastic modulus recovery ratio of at least one layer that is adjacent to the gas barrier layer satisfy 0.5 GPa ≤ hardness ≤ 5. 0 GPa and 50% ≤ elastic modulus recovery ratio ≤ 100% as measured by a nanoindentation method.
Furthermore, the other embodiments of the invention are described below.
2. The gas barrier film according to the item 1, wherein the hardness and the elastic modulus recovery ratio of at least one layer that is adjacent to the gas barrier layer satisfy 0.7 GPa ≤ hardness ≤2.0 GPa and 60% ≤ elastic modulus recovery ratio ≤ 90% as measured by a nanoindentation method.
3. The gas barrier film according to the item 1 or 2, wherein the gas barrier layer contains a metal oxide, a metal nitride, or a metal oxynitride.
4. The gas barrier film according to the item 3, wherein a metal in the metal oxide, metal nitride, or metal oxynitride comprises at least one metal selected from the group consisting of Si, Al, and Ga.
5. A method for producing the gas barrier film according to any one of the items 1 to 4, wherein at least one layer that is adjacent to the gas barrier layer is formed by performing conversion treatment to a precursor layer formed by coating.
6. A method for producing the gas barrier film according to any one of the items 1 to 4, wherein the gas barrier layer is formed by performing conversion treatment to a precursor layer formed by coating.

Advantageous Effects of Invention

According to the present invention, a gas barrier film having high gas barrier performance and a method of producing a gas barrier film with excellent continuous productivity can be provided.

## BRIEF DESCRIPTION OF DRAWINGS

Fig. 1 is a view showing one example of a load-displacement curve obtained according to a typical nanoindentation method.
Fig. 2 is a view showing one example of a condition of contact of a diamond penetrator with a sample in a measurement according to the nanoindentation method.

## DESCRIPTION OF EMBODIMENTS

Hereinbelow, best embodiments for carrying out the present invention will be described, but the invention is not limited thereto.

<Layer adjacent to gas barrier layer>

The gas barrier film of the present invention is obtained by laminating at least one gas barrier layer on a resin substrate (for example, polyethylene terephthalate), and for the physical properties of the at least one layer that is adjacent to the gas barrier layer, the hardness is 0.5 GPa or more and 5.0 GPa or less and the elastic modulus recovery ratio is 50% or more and 100% or less, which are measured by a nanoindentation method. The inventors of the present application found that gas barrier performance is improved by having such structure. The layer that is adjacent to the gas barrier layer satisfies 0.5 GPa ≤ hardness ≤ 5.0 GPa and 50% ≤ elastic modulus recovery ratio ≤ 100% as measured by a nanoindentation method may be also referred to simply as an adjacent layer hereinafter. From the viewpoint of a moisture transmission ratio, the hardness is preferably 0.7 GPa or more and 2.5 GPaorless, and the elastic modulus recovery ratio is preferably 60% or more and 90% or less, and from the viewpoint of an initial value of a water vapor transmission ratio and keeping the initial values of a water vapor transmission ratio, the hardness is more preferably 0.7 GPa or more and 2.0 GPa or less, and an elastic modulus recovery ratio is more preferably 60% or more and 90% or less.

When the hardness is less than 0.5 GPa, an adjacent layer does not become a satisfactory one in view of gas barrier performance, in particular, a moisture transmission ratio. In addition, when the hardness exceeds 5.0 GPa, internal stress in an adjacent layer is large in the case of adding an external force, and cracks are easily generated in the adjacent layer. On the other hand, even though the above described physical property of hardness is satisfied, when an elastic modulus recovery ratio is less than 50%, that is, a ratio of a plastic deformation amount to the entire deformation amount is large, cracks may be generated in a gas barrier layer immediately after forming the gas barrier layer or in a short time after initiating an evaluation of gas barrier performance in the Ca corrosion method. This is assumed to be caused by plastic deformation of a base or an intermediate layer due to fracture stress worked in a barrier film by intrusion of water vapor.

A hardness and an elastic modulus recovery ratio of a layer that is adjacent to a gas barrier layer in the present invention is calculated in the nanoindentation method.

The nanoindentation method is a method of measuring a hardness and an elastic modulus (reduced modulus) from an obtained load-displacement curve by continuously loading and unloading a penetrator with a very small load onto a sample.

(Measurement principle of the nanoindentation method)

The nanoindentation method is a newest measurement method which is capable of measuring an indentation hardness at a nano level by adding a module for an indentation hardness measurement (constituted with a transducer and an indentation tip) to an atomic force microscope (AFM). While a maximum load of 20 μN or less is added, a diamond penetrator with a tip radium of about 0.1 to 1 μm is pushed into a sample being a measurement object and an indentation depth is measured to an accuracy of nanometer. A load-displacement curve figure is obtained from this measurement, and characteristics of elasto-plastic deformation of a material can be quantitatively evaluated. For a measurement without receiving affection of a substrate in the case of a thin film, a diamond penetrator is required to be pushed into a depth of 1/10 to 1/3 of the film thickness. In this nanoindentation method, a measurement can be carried out to a high accuracy of 0.01 nm as a displacement resolution using a head assembly with an ultralow load, for example, the maximum load of 20 μN and a load resolution of 1 nN.

Fig. 1 shows one example of a load-displacement curve obtained according to a typical nanoindentation method. In Fig. 1, the gradient S refers to a gradient of an unload curve (= dP/dh), and is specifically found by using a gradient of an unload curve in the maximum load $P_{max}$, focusing on an initial stage of unloading that could be simple elasticity recovery.

Fig. 2 is a view showing one example of a condition of contact of a diamond penetrator and a sample in a measurement of a hardness and an elastic modulus recovery ratio measured by the nanoindentation method. In Fig. 2, 1 indicates an initial surface of a sample when a penetrator does not contact, 2 indicates a profile of the sample surface when a load is charged through the penetrator, and 3 indicates a profile of the sample surface after removing the penetrator.

The hardness H is found from the formula of H = W/A (W denotes a load, A denotes a contact area). However, since a load is very small in the nanoindentation method, A cannot be directly obtained from indentation, and the like. Specifically, the following method is used in the present invention.

As shown in Fig. 2, the formula of $hc = ht - \varepsilon \cdot W/S$ ($\varepsilon$ denotes a constant number inherent in a penetrator, S denotes a gradient described in Fig. 1) is formed for hc, herein $\varepsilon$ is a constant number inherent in a penetrator, which is determined by a geometric shape of the penetrator, and in conical and Berkovich penetrators, and triangular penetrators such as cube corner penetrator, $\varepsilon$= 0.726 is used, in a spherical penetrator, $\varepsilon$= 0.75 is used, and in a cylindrical penetrator, $\varepsilon$ = 1 is used.

In the case of a triangular penetrator, A is expressed by the following formula from a geometric shape, assuming

an angle formed by the central axis and the side surface of the triangular pyramid to be $\alpha$.

[Mathematical Formula 1]

$$A = C_1 hc^2, \ C_1 = 3 \times 3^{1/2} \tan^2\alpha$$

In a Berkovich penetrator, because of $\alpha$ = 65.27°, $C_1$ becomes 24.56, A = 24.56$hc^2$. In addition, in a cube corner penetrator, $\alpha$ = 45°, C1 becomes 5.196, and A = 5.196 $hc^2$. Accordingly, H can be obtained when ht, W and S are found.

In addition, complex elastic modulus Er can be calculated from Er = $S \cdot \pi^{1/2}/2/A^{1/2}$. It is presumed that when Er is large, plastic deformation easily occurs, and when it is small, elastic deformation easily occurs.

An elastic modulus recovery ratio is defined with a ratio (%) of a gap of displacement magnitude (hc) at which a load is 0 when a penetrator is set back from the maximum displacement magnitude to the maximum displacement magnitude (ht)= 100 $\times$ hc/ht.

In the present invention, a hardness and an elastic modulus recovery ratio are measured using a nano indenter (Nano Indenter TMXP/DCM) manufactured by MTS Systems Corporation. A used penetrator is a cube corner tip (90°).

A sample size is 20 mm$\phi$ $\times$ 10 mm at maximum, and a sample is fixed to a sample table with an adhesive agent, or the like. Since a load range of the device is a very low load such as 10 mN or less than 10 mN, the device is suitable for measurements of a hardness and an elastic modulus of a thin film with a film thickness of about several 10 nm to 1 $\mu$m.

In measurements of a hardness and an elastic modulus recovery ratio of an adjacent layer, respective physical properties are to be measured in a stage when a layer to be measured is the top layer in a production stage. For example, when an adjacent layer is present between a substrate and a gas barrier layer (for example, when an adjacent layer is an underlying layer that is described later), physical properties are measured before forming a gas barrier layer after forming an adjacent layer. Inaddition, when an adjacent layer is a protecting layer described later, physical properties are measured after forming a protecting layer on a gas barrier layer. Furthermore, in the case of a multiple layer, for example, in the case of a film such as a resin substrate-underlying layer 1-gas barrier layer-protecting layer 2 (underlying layer)-gas barrier layer, measurements are carried out as in a resin substrate-underlying layer 1 (measurement)-gas barrier layer-protecting layer 2 (underlying layer) (measurement)-gas barrier layer.

Note that when an adjacent layer is in a form of two or more layers, physical properties thereof are prescribed as those in a state of a laminated layer.

In order that a hardness and an elastic modulus recovery ratio of a layer adjacent to a gas barrier layer satisfy 0.5 GPa $\leq$ hardness $\leq$ 5. 0 GPa and 50% $\leq$ elastic modulus recovery ratio $\leq$ 100% in a measurement by the nanoindentation method, examples for a layer adjacent to a gas barrier layer include a layer formed from an inorganic polymer (oligomer) material having polysilazane or polysiloxane as the main skeleton and a layer obtained by using an inorganic/organic nanocomposite material having an inorganic skeleton as the main component, which have high inorganic component ratios and are capable of forming three dimensional crosslinking structures.

An inorganic polymer material may contain a functional group ($C_nH_{2n+1}$) containing carbon in its skeleton, but when the number of carbon is too large, it is difficult to achieve a balance between a hardness and an elastic modulus recovery ratio. The number of carbon n contained in the inorganic skeleton is preferably 0 to 5, and more preferably 1 to 3. When the number of carbon is 5 or less, the hardness and the elastic modulus recovery ratio can be easily within the range of the present invention. This is because promotion of a three dimensional crosslinking reaction due to a post curing treatment as described later seems to easily proceed.

(Polysilazane)

Hereinafter, polysilazane will be described.

Polysilazane is a polymer having a silicon-nitrogen bond, and a ceramic precursor inorganic polymer including $SiO_2$, $Si_3N_4$ and an intermediate solid solution of both of $SiO_2$ and $Si_3N_4$, such as $SiO_xN_y$, which have bonds such as Si-N, Si-H and N-H.

For polysilazane, a compound having a structure expressed by the following general formula (I) is preferable. [Formula 1]

General Formula (I) $-(SiR_1R_2-NR_3)_n-$

In the above described general formula (I), $R_1$, $R_2$ and $R_3$ are the same or different, and each is independently a hydrogen atom; a substituted or unsubstituted alkyl group, aryl group, vinyl group or (trialkoxysilyl) alkyl group. Herein,

examples of the alkyl group include linear, branched, or cyclic alkyl groups having 1 to 8 carbon atoms. More specifically, examples include a methyl group, an ethyl group, an n-propyl group, an isopropyl group, an n-butyl group, an isobutyl group, a sec-butyl group, a tert-butyl group, an n-pentyl group, an isopentyl group, a neopentyl group, an n-hexyl group, an n-heptyl group, an n-octyl group, a 2-ethylhexyl group, a cyclopropyl group, a cyclopentyl group, and a cyclohexyl group. For the aryl group, examples include aryl group having 6 to 30 carbon atoms. More specifically, examples include non-condensed hydrocarbon groups such as a phenyl group, a biphenyl group and a terphenyl group; condensed polycyclic hydrocarbon groups such as a pentalenyl group, an indenyl group, a naphthyl group, an azulenyl group, a heptalenyl group, a biphenylenyl group, a fluorenyl group, an acenaphthylenyl group, a playadenyl group, an acenaphthenyl group, a phenalenyl group, a phenanthryl group, an anthryl group, a fluoranthenyl group, an acephenanthrenyl group, an aceanthrenyl group, a triphenylenyl group, a pyrenyl group, a chrysenyl group, and a naphthacenyl group. For the (trialkoxysilyl) alkyl group, examples include alkyl group having 1 to 8 carbon atoms, which has a silyl group substituted with an alkoxy group having 1 to 8 carbon atoms. More specifically, examples include a 3-(triethoxysilyl)propyl group and 3-(trimethoxysilyl)propyl group. A substituent that is present in the above described $R_1$ to $R_3$ depending on cases is not particularly limited, and examples thereof include an alkyl group, a halogen atom, a hydroxyl group (-OH), a mercapto group(-SH), a cyano group (-CN), a sulfo group ($-SO_3H$), a carboxyl group (-COOH), and a nitro group ($-NO_2$). Note that the substituent that is present depending on cases is never the same as $R_1$ to $R_3$ to be substituted. For example, when $R_1$ to $R_3$ are alkyl groups, there is no case of further substitution with an alkyl group. Among the substituents $R_1$, $R_2$ and $R_3$ each is preferably a hydrogen atom, a methyl group, an ethyl group, a propyl group, an isopropyl group, a butyl group, an isobutyl group, a tert-butyl group, a phenyl group, a vinyl group, a 3-(triethoxysilyl)propyl group or a 3-(trimethoxysilyl propyl) group. $R_1$, $R_2$ and $R_3$ each is preferably independently a group selected from the group consisting of a hydrogen atom, a methyl group, an ethyl group, a propyl group, an iso-propyl group, a butyl group, an iso-butyl group, a tert-butyl group, a phenyl group, a vinyl group, a 3-(triethoxysilyl)propyl group and a 3-(trimethoxysilyl)propyl group.

In the above described general formula (I), n is an integer, and n is defined that polysilazane having a structure expressed by the general formula (I) has a number average molecular weight of 150 to 150,000 g/mol.

One preferable embodiment in a compound having a structure expressed by the general formula (I) is perhydropolysilazane wherein all of $R_1$, $R_2$ and $R_3$ are hydrogen atoms from the viewpoint of precision of an obtained polysilazane layer. Perhydropolysilazane is presumed to have a structure with a linear structure and a cyclic structure centering on the 6 and 8-membered rings. The molecular weight is about 600 to 2,000 (polystyrene conversion) as a number average molecular weight (Mn), and perhydropolysilazane is a liquid or solid substance and the state is different depending on its molecular weight.

In addition, as another polysilazane, a compound having a structure expressed by the following general formula (II) is preferable.

[Formula 2]

General Formula (II) $-(SiR_1R_2-NR_3)_n-(SiR_4R_5-NR_6)_p-$

In the above described general formula (II), $R_1$, $R_2$, $R_3$, $R_4$, $R_5$ and $R_6$ each independently denotes a hydrogen atom, a substituted or unsubstituted alkyl group, aryl group, vinyl group, or (trialkoxysilyl)alkyl group, n and p are integers, n is defined that polysilazane having a structure expressed by the general formula (I) has a number average molecular weight of 150 to 150,000 g/mol. The substituted or unsubstituted alkyl group, aryl group, vinyl group, or (trialkoxysilyl)alkyl group in the above description is defined in the same manner as the above described general formula (I) and the explanation thereof is thus omitted. Note that n and p may be the same or different.

In the above described general formula (II), a particularly preferable compounds include a compound wherein $R_1$, $R_3$ and $R_6$ each represents a hydrogen atom, $R_2$, $R_4$ and $R_5$ each represents a methyl group, a compound wherein $R_1$, $R_3$ and $R_6$ each represents a hydrogen atom, $R_2$ and $R_4$ each represents a methyl group, and $R_5$ represents a vinyl group, and a compound wherein $R_1$, $R_3$, $R_4$ and $R_6$ each represents a hydrogen atom, and $R_2$ and $R_5$ each represents a methyl group.

Furthermore, as the other polysilazane, a compound having a structure expressed by the following general formula (III) is preferable.

[Formula 3]

General Formula (III) $-(SiR_1R_2-NR_3)_n-(SiR_4R_5-NR_6)_p-(SiR_7R_8-NR_9)_q-$

In the above described general formula (III), $R_1$, $R_2$, $R_3$, $R_4$, $R_5$, $R_6$, $R_7$, and $R_9$ each independently represents a hydrogen atom, a substituted or unsubstituted alkyl group, aryl group, vinyl group or (trialkoxysilyl)alkyl group. n, p and q each is an integer, and n is defined so that polysilazane having a structure expressed by the general formula (III) has a number average molecular weight of 150 to 150,000 g/mol. The substituted or unsubstituted alkyl group, aryl

group, vinyl group or (trialkoxysilyl)alkyl group in the above description is the same as the definition in the general formula (I) and the explanation is thus omitted. Note that n, p and q may be the same or different.

In the above described general formula (III), particularly preferable is a compound in which $R_1$, $R_3$ and $R_6$ each represents a hydrogen atom, $R_2$, $R_4$, $R_5$ and $R_8$ each represents a methyl group, $R_9$ represents a (triethoxysilyl) propyl group, and $R_7$ represents an alkyl group or a hydrogen atom.

On the other hand, organopolysilazane in which a part of a hydrogen atom moiety bonded to Si is substituted with an alkyl group, or the like, can be improved in adhesivity to a substrate being a base by having an alkyl group such as a methyl group, and allow a ceramic film made of hard and fragile polysilazane to have toughness and has an advantage of suppressing generation of cracks even in the case of making a (mean) film thickness large. These perhydropolysilazane and organopolysilazane may be suitably selected according to uses and can be used in mixing.

Other examples of a polysilazane compound include polysilazanes formed into ceramics at low temperatures such as silicon alkoxide adduct polysilazane obtained by reacting silicon alkoxide with the above described polysilazane (Japanese Patent Laid-Open No. 5-238827), glycidol adduct polysilazane obtained by reacting glycidol (Japanese Patent Laid-Open No. 6-122852), alcohol adduct polysilazane obtained by reacting an alcohol (Japanese Patent Laid-Open No. 6-240208), metal carboxylic acid salt adduct polysilazane obtained by reacting a metal carboxylic acid salt (Japanese Patent Laid-Open No. 6-299118), acetyl acetonate complex adduct polysilazane obtained by reacting an acetyl acetonate complex containing a metal (Japanese Patent Laid-Open No. 6-306329), and metal powder adduct polysilazane obtained by adding metal powder (Japanese Patent Laid-Open No.7-196986).

In order to form an adjacent layer usingpolysilazane, for example, the adjacent layer can be formed in a coating method using a polysilazane coating liquid, without particularly limitation. A solvent can be used for coating liquid, and a ratio of polysilazane in the solvent is generally 1 to 80% by mass of polysilazane, preferably 5 to 50% by mass, and particularly preferably 10 to 40% by mass.

Such a solvent is preferably an organic based solvent that does not particularly contain water and reactive groups (e.g., a hydroxyl group or an amine group) and is inactive to polysilazane, and an aprotic solvent is favorable.

As a solvent applicable to a polysilazane coating liquid, aprotic solvents can be included; for example, solvents of hydrocarbons including aliphatic hydrocarbons and aromatic hydrocarbons, such as pentane, hexane, cyclohexane, toluene, xylene, solvesso and turpentine; halogen hydrocarbon solvents such as methylene chloride and trichloroethane; esters such as ethyl acetate and butyl acetate; ketones such as acetone and methyl ethyl ketone; ethers such as tetrahydrofuran, a dibutyl ether, mono- and polyalkyleneglycol dialkyl ethers (diglymes), or a mixture of these solvents. The above described solvents are selected according to purposes such as a solubility of polysilazane and an evaporation rate of a solvent, and may be used singly or in a mixture form of two or more of these solvents.

Polysilazane is commercially available in a state of a solution dissolved in an organic solvent, and such a commercially available product can be directly used as a polysilazane coating liquid. Examples of a commercially available product include AQUAMICA manufactured by AZ Electronic Materials Co. (registered trademark) NN120-10, NN120-20, NAX120-10, NAX120-20, NN110, NN310, NN320, NL110A, NL120A, NL150A, NP110, NP140, and SP140.

A catalyst may be contained at the same time with polysilazane in a polysilazane coating liquid. An applicable catalyst is preferably a basic catalyst, and particularly preferably N,N-diethyl ethanolamine, N,N-dimethyl ethanolamine, triethanolamine, triethylamine, 3-morpholinopropylamine or an N-heterocyclic compound. A concentration of an adding catalyst is generally within the range from 0.1 to 10% by mol, and preferably from 0.5 to 7% by mol based on polysilazane.

The following additives can be used in apolysilazane coating liquid according to necessity. Examples include cellulose ethers, cellulose esters; e.g., ethylcellulose, nitrocellulose, cellulose acetate, and cellulose acetobutylate, natural resins; e.g., rubbers and rosin resins, synthetic resins;e.g.,polymerized resins,condensed resins; e.g., aminoplast, in particular, urea resin, melamine formaldehyde resin, alkyd resin, acrylic resin, polyester or modified polyester, epoxide, polyisocyanate, or blocked polyisocyanate, and polysiloxane.

An adding amount of the other additives is preferably 10% by mass or less, and more preferably 5% by mass or less, assuming that the whole amount of the second barrier layer is 100% by mass.

A dry treatment and a conversion treatment such as an ultraviolet ray irradiation treatment is preferably suitably carried out after coating a polysilazane coating liquid in order to form a three dimensional crosslinking structure. When a dry treatment is performed, the dry conditions may be suitably set so as to make a reaction progress, and drying at 20 to 40°C for 1 to 4 days is preferable.

In addition, when polysilazane is used in an adjacent layer, a layer constituted with an acrylic resin, an urethane resin, and the like before forming a polysilazane layer is preferably formed from the viewpoint of having a constitution which can ease more stress due to substrate deformation.

(Polysiloxane)

Polysiloxane used in the present invention is preferably polysiloxane having a three dimensional crosslinking structure. For such polysiloxane, an example includes polysiloxane shown in (B) described below, which is obtained by

condensation of siloxane oligomer shown in (A) described below.

[Formula 4]

(A)

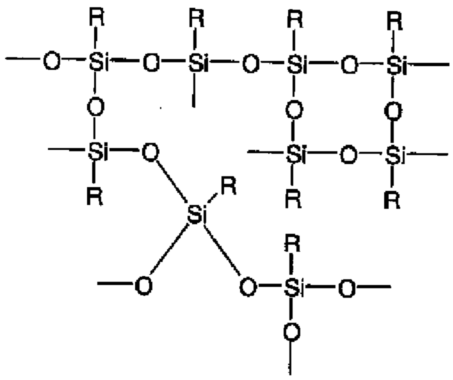

(B)

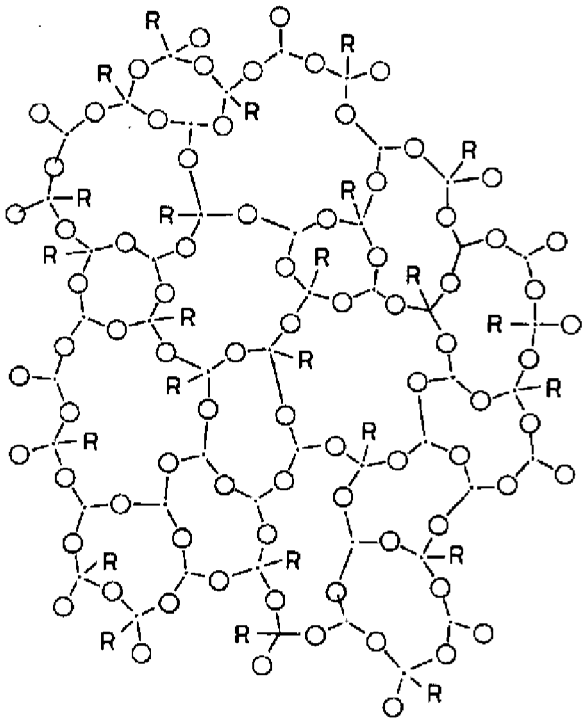

In each of the above described (A) and (B), R represents a linear, branched or cyclic alkyl group having 1 to 20 carbon atoms or an aryl group having 6 to 30 carbon atoms. Specific examples of R include a methyl group, an ethyl group, a (n, i)-propyl group, a (n, i, sec, tert)-butyl group, and a phenyl group, and in particular, a methyl group and a phenyl group are preferable. Note that a black circle denotes a Si atom and a white circle denotes an oxygen atom in the above described (B).

The number average molecular weight (Mn) of the above described siloxane oligomer shown in (A) is preferably $10^3$ to $10^6$. Note that an end of a siloxane oligomer is generally Si-OH.

In order to form an adjacent layer of polysiloxane from a siloxane oligomer, although there is no particular limitation, the adjacent layer can be formed, for example, by a coating method using a siloxane oligomer coating liquid. A solvent can be used for the coating liquid, and a ratio of siloxane oligomer in the solvent is generally 10 to 30% by mass of the siloxane oligomer.

Examples of such a solvent include hydroalcoholic, alcoholic, aromatic and ester-based solvents, and preferably alcoholic solvents.

A siloxane oligomer shown in (A) is commercially available in a state of a solution dissolved in an organic

solvent, and a commercially available product can be directly used as a siloxane oligomer coating liquid. Examples of commercially available products include ceramic coating materials, Glassca (HPC7003, HPC7004, HPC7516) manufactured by JSR CORPORATION.

A technique of coating a coating liquid to form an adjacent layer of an inorganic polymer material is not particularly limited, and general methods including, for example, a cast method, a spin coating method, a blade coating method, a wire bar coating method, a gravure coating method, a spray coating method, and a dipping (immersion) coating method can be used.

Forming a three dimensional crosslinking structure from an inorganic polymer material can be realized by addition of a thermal treatment generally at 200°C or more, but film formation on a resin substrate with low heat resistance is difficult. As a result of intensive studies made by the present inventors, coating films of these materials are generated on a resin substrate and solvent removal and an initial curing reaction (procuring treatment) are carried out by a thermal treatment at a heat resistant temperature of a resin substrate or less, thereafter irradiating a high energy line, for example, a vacuum ultraviolet ray with a wavelength of 200 nm or less (post curing treatment), thereby making it possible to adjust film physical properties within the range of the present invention without giving a damage to a resin substrate. This will be described in (conversion treatment of layer adjacent to gas barrier layer) that is described later.

(Inorganic organic nanocomposite material)

Nanocomposite is the generic term of a complex material obtained by kneading an organic material that is granulated into a size of 1 to 100 nm into an inorganic material. An inorganic organic nanocomposite material is required to be able to be cured and formed into a layer.

Also in the case of an inorganic organic nanocomposite material, adjustment of film physical properties is possible by a similar post curing treatment, but a network of an inorganic skeleton is required to be a main constituent. That is, when a ratio of an organic component is too large, a network of an inorganic skeleton is divided and a hardness is low or plastic deformation is significant. In the present invention, when an inorganic organic nanocomposite material is used, a ratio of a dispersed organic component is preferably set to 0.1 to 10% by mass, and more preferably 1 to 5% by mass. Setting such a ratio enables formation of a sea-island structure having "an island" of an organic material dispersed in a nano level in "the sea" of the inorganic skeleton material, and film formation of a layer that achieves a balance between a hardness and an elastic modulus recovery ratio is possible. For such an inorganic skeleton material, examples include siloxane polymers, and examples of an organic material include acryl and urethane. For such an inorganic organic nanocomposite material, a commercially available product can be directly used. An example of a commercially available product include SSG Coat Series (such as SSG Coat HB21B) manufactured by NITTO BOSEKI CO., LTD.

The sea island ratio of a sea-island structure is adjusted and three dimensional crosslinking of an inorganic skeleton proceeds, which also makes it possible to achieve physical properties of the present invention without performing a post curing treatment by a high energy line. When a post curing treatment is not performed, a coated film is preferably dried after coating a coating liquid in order to prepare an adjacent layer formed from an inorganic organic nanocomposite material. A drying temperature is preferably 50 to 200°C, and more preferably 80 to 150°C. A drying time is preferably 0.001 to 20 hours and more preferably 0.03 to 1 hour.

When a layer with the above described physical properties is provided as a layer (referred to as an underlying layer) which is adjacent to the side of a substrate (resin substrate) to a gas barrier layer, delay of a time until generation of corrosion is possible in a gas barrier performance evaluation by a Ca corrosion method described later. It is presumed that this phenomenon is caused by improvement of gas barrier performance as a result of improvement of film quality of a gas barrier layer due to escaping internal stress generated at the time of forming the adjacent gas barrier layer. That is, in the gas barrier film of one preferable embodiment of the present invention, an adjacent layer is arranged between a gas barrier layer and a substrate.

In addition, when a layer with the above described physical properties is provided as a layer (referred to as a protecting layer) which is adjacent to the opposite side of a substrate (resin substrate) to a gas barrier layer, it was found that an increase ratio of Ca corrosion hardly changed between an initial stage of corrosion generation at a corrosion ratio of around 1% and a corrosion advanced stage at a corrosion ration of around 50% in the Ca corrosion evaluation. This phenomenon is assumed to show that breaking is hardly promoted when stress is added from the outside, which improves a function of protecting a gas barrier layer that easily has cracks by external force because of a precise inorganic layer. Therefore, it is presumed that gas barrier performance in an initial stage can be kept for a long period of time. That is, in a gas barrier film of another preferable embodiment of the present invention, an adjacent layer is arranged on a gas barrier layer in the opposite side of the substrate.

Note that a combination use of an underlying layer and a protecting layer as a layer with the above described physical properties is more preferable from the viewpoint of gas barrier performance.

As a result of intensive studies made of the present inventors, they found that values of a hardness and an

elastic modulus recovery ratio of an underlying layer and a protecting layer simply measured in the nanoindentation method are insufficient for improvement and maintenance of gas barrier performance and it is necessary to satisfy both of the hardness and the elastic modulus recovery ratio within specific ranges.

Note that "gas barrier performance" in the present application means that a water vapor transmission degree (60 $\pm$ 0.5°C, relative humidity (90 $\pm$ 2) %H) measured in the method according to JIS K 7129-1992 is 1 $\times$ $10^{-2}$ g/ ($m^2 \cdot 24$ h) or less, and an oxygen transmission degree measured in the method according to JIS K 7126-1987 is 1 $\times$ $10^{-2}$ ml/$m^2 \cdot 24$ h·atm or less. All of examples described later satisfy the above described characteristics.

(Underlying layer)

As an important function of an underlying layer, the underlying layer is supposed to have a function such as dispersing a film formation stress of a gas barrier layer, and to suppress generation of defects such as cracks caused in film forming as described above. In order to exert this function, it is considered to be required to have a certain level of a hardness for dispersing a film formation stress of a gas barrier layer toward a thickness direction and that, when a film formation stress of the gas barrier layer is added, an underlying layer itself does not break.

In the studies made by the present inventors, when a hardness of an underlying layer is 0.5 GPa or more, cracks are hardly generated in a gas barrier layer and film curl made by a gas barrier layer curled inside is small, and when a hardness of an underlying layer is 5.0 GPa or less, cracks in the underlying layer itself are hardly generated. Furthermore, even within the above described range of a hardness, when an elastic modulus recovery ratio is less than 50%, that is, a ratio of plastic deformation amount to an entire deformation amount is large, cracks may be generated in a gas barrier layer immediately after forming the gas barrier layer, or within a short time after initiating an evaluation of gas barrier performance in the Ca corrosion method.

That is, it is found that physical properties of a layer with a small plastic deformation (destruction) to stress generated during film formation or after film formation is necessary, in addition that film formation stress of a gas barrier layer (particularly, stress in the lateral direction) is diffused to ovoid concentration of stress to the boundary between an underlying layer and the gas barrier layer, or residual stress in the gas barrier layer is decreased.

The underlying layer according to the present invention can also be doubled as a smoothing layer and a bleed-out prevention layer.

A smoothing layer is provided for planarization of a coarse surface of a resin substrate (support) where protrusions, and the like are present, or planarization by filling unevenness and pin holes generated in an adjacent layer due to protrusions present in a resin substrate. Such a smoothing layer is formed by basically curing photo-curable materials (photosensitive materials) or thermosetting materials.

A bleed-out prevention layer is provided on an opposite side of a resin substrate having a smoothing layer for the purpose of suppressing a phenomenon in which, when a filmhaving a smoothing layer is heated, unreacted oligomer, and the like, are transferred to a surface from a film support and contaminates a contact surface. A bleed-out prevention layer may basically have the same structure as the smoothing layer as long as it has this function.

A material of an underlying layer (also including a smoothing layer and a bleed-out prevention layer) is not particularly limited as long as physical properties of the present invention can be realized and, for example, an underlying layer is formed by curing photo-curable materials (photosensitive materials) or thermosetting materials. In addition, the physical properties of the present invention may also be realized as a result from laminating or mixing different kinds of materials.

Examples of photocurable materials include a resin composition containing an acrylate compound having a radical reactive unsaturated compound, a resin compound containing an acrylate compound and a mercapto compound having a thiol group, and resin compounds obtained by dissolving multifunctional acrylate monomers such as epoxy acrylate, urethane acrylate, polyester acrylate, polyether acrylate, polyethyleneglycol acrylate, and glycerol methacrylate. In addition, any mixture of resin compositions as described above can also be used, and there is no particular limitation as long as the photocurable material is a photocurable resin that contains a reactive monomer having one or more photopolymerizable unsaturated bonds in a molecule.

Examples of reactive monomers having one or more photopolymerizable unsaturated bonds in a molecule include methylacrylate,ethylacrylate,n-propylacrylate,isopropyl acrylate, n-butyl acrylate, isobutyl acrylate, tert-butyl acrylate, n-pentyl acrylate, n-hexyl acrylate, 2-ethylhexyl acrylate, n-octyl acrylate, n-decyl acrylate, hydroxyethyl acrylate, hydroxypropyl acrylate, allyl acrylate, benzyl acrylate, butoxyethyl acrylate, butoxyethyleneglycol acrylate, cyclohexyl acrylate, dicyclopentanyl acrylate, 2-ethylhexyl acrylate, glycerol acrylate, glycidyl acrylate, 2-hydroxyethyl acrylate, 2-hydroxypropyl acrylate, isobornyl acrylate, isodexyl acrylate, isooctyl acrylate, lauryl acrylate, 2-methoxyethyl acrylate, methoxyethyleneglycol acrylate, phenoxyethyl acrylate, stearyl acrylate, ethyleneglycol diacrylate, diethyleneglycol diacrylate, 1,4-butanediol diacrylate, 1,5-pentanediol diacrylate, 1,6-hexadiol diacrylate, 1,3-propanediol acrylate, 1,4-cyclohexanediol diacrylate, 2,2-dimethylolpropane diacrylate, glycerol diacrylate, tripropylene glycol diacrylate, glycerol triacrylate, trimethylolpropane triacrylate, polyoxyethyl trimethylolpropane triacrylate, pentaerythritol triacrylate, pentaerythritol tetraacrylate, ethylene oxide modified pentaerythritol triacrylate, ethylene oxide modified pentaerythritol tetraacrylate, propylene oxide modified pentaerythritol triacrylate, propylene oxide modified pentaerythritol tetraacrylate, triethylene glycol diacrylate, polyoxypropyl trimethylolpropane triacrylate, butyleneglycol diacrylate, 1,2,4-butanediol triacrylate, 2,2,4-trimethyl-1,3-pentadiol diacrylate, diallyl fumarate, 1,10-decanedioldimethyl acrylate, and pentaerythritol hexaacrylate, and methacrylates converted from the above described acrylates, γ-methacryl oxypropyl trimethoxysilane, and 1-vinyl-2-pyrrolidone. The above described reactive monomers can be used as a mixture of two or more monomers, or a mixture with other compounds.

A composition of a photosensitive resin contains a photopolymerization initiator. Examples of the photopolymerization initiator include benzophenone, o-benzoylmethyl benzoate, 4,4-bis(dimethylamine)benzophenone, 4,4-bis(diethylamine)benzophenone, α-amino·acetophenone, 4,4-dichlorobenzophenone, 4-benzoyl-4-methyl diphenyl ketone, dibenzyl ketone, fluorenone, 2,2-diethoxyacetophenone, 2,2-dimethoxy-2-phenylacetophenone, 2-hydroxy-2-methylpropiophenone, p-tert-butyl dichloroacetophenone, thioxanthone, 2-methylthioxanthone, 2-chlorothioxanthone, 2-isopropylthioxanthone, diethylthioxanthone, benzyldimethyl ketal, benzylmethoxyethyl acetal, benzoinmethyl ether, benzoinbutyl ether, anthraquinone, 2-tert-butylanthraquinone, 2-amylanthraquinone, β-chloranthraquinone, anthrone, benzanthrone, dibenzosuberone, methyleneanthrone, 4-azidobenzylacetophenone, 2,6-bis(p-azidobenzylidene)cyclohexane, 2,6-bis(p-azidobenzylidene)-4-methylcyclohexanone, 2-phenyl 1,2-butadione-2-(o-methoxycarbonyl)oxime, 1-phenyl-propanedione-2-(o-ethoxycarbonyl)oxime, 1,3-diphenylpropanetrione-2-(o-ethoxycarbonyl) oxime, 1-phenyl-3-ethoxy-propanetrione-2-(o-benzoyl)oxime, Michler ketone, 2-methyl[4-(methylthio)phenyl]-2-morpholino-1-propane, 2-benzyl-2-dimethylamino-1-(4-morpholinophenyl)-butanone -1, naphthalenesulfonyl chloride, quinolinesulfonyl chloride, n-phenylthioacridone,4,4-azobisisobutylonitrile, diphenyl disulfide, benzothiazol disulfide, triphenylphosphine, camphorquinone, carbon tetrabromide, tribromophenyl sulfone, benzoine peroxide, eosine, and combinations of photoreducing compounds such as methylene blue and reducing agents such as ascorbic acid and triethanol amine, and combinations of one or more of these photopolymerization initiators can be used.

A method of forming a smoothing layer is not particularly limited, and the smoothing layer is preferably formed in wet coating methods such as a spin coating method, a spray method, a blade coating method and a dip method, or a dry coating method such as a vapor deposition method.

In formation of a smoothing layer, additives such as an antioxidant, an ultraviolet absorber, and a plasticizer can be added to the above described photosensitive resins, according to necessity. In addition, suitable resins and additives for improvement of film formation and prevention of generation of pin holes in a film may also be used in any smoothing layer without relation to a lamination position of the smoothing layer.

Examples of a solvent used in forming a smoothing layer by use of a coating liquid obtained by dissolving or dispersing a photosensitive resin into a solvent include alcohols such as methanol, ethanol, n-propanol, isopropanol, ethylene glycol and propylene glycol, terpenes such as α- or β-terpineol, ketones such as acetone, methyl ethyl ketone, cyclohexanone, N-methyl-2-pyrrolidone, diethyl ketone, 2-heptanone and 4-heptanone, aromatic hydrocarbons such as toluene, xylene, and tetramethyl benzene, glycol ethers such as cellosolve, methyl cellosolve, ethyl cellosolve, carbitol, methyl carbitol, ethyl carbitol, butyl carbitol, propylene glycol monomethyl ether, propylene glycol monoethyl ether, dipropylene glycol monomethyl ether, dipropylene glycol monoethyl ether, triethylene glycol monomethyl ether, and triethylene glycol monoethyl ether, acetic acid esters such as ethyl acetate, butyl acetate, cellosolve acetate, ethyl cellosolve acetate, butyl cellosolve acetate, carbitol acetate, ethyl carbitol acetate, butyl carbitol acetate, propylene glycol monomethyl ether acetate, propylene glycol monoethyl ether acetate, 2-methoxyethyl acetate, cyclohexyl acetate, 2-ethoxyethyl acetate, and 3-methoxybutyl acetate, and diethylene glycol dialkyl ether, dipropylene glycol dialkyl ether, ethyl-3-ethoxy propionate, methyl benzoate, N,N-dimethylacetoamide, and N,N-dimethyl formamide.

Examples of thermosetting materials include a thermosetting urethane resin made of acryl polyol and an isocyanate prepolymer, a phenol resin, a urea melamine resin, an epoxy resin, an unsaturated polyester resin, a silicone resin, and polysilazane, polysiloxane, titanium oligomer, and further, inorganic organic nanocomposite materials obtained by dispersing resin components in an inorganic skeleton at a nano level.

As a material that realizes physical properties of a relatively high hardness and high elastic modulus recovery ratio as the present invention, an inorganic polymer (oligomer) material having polysilazane or polysiloxane as a main skeleton, and an inorganic organic nanocomposite material having an inorganic skeleton as a main constituent, which have a high inorganic component ration and can have a three dimensional crosslinking structure, are particularly preferable.

A thickness of an underlying layer in the present invention is preferably 0.1 to 10 μm, and more preferably 1 to 7 μm. Setting the thickness to 0.1 μm or more easily makes a film having an underlying layer have sufficient smoothness, and setting the thickness to 10 μm or less can facilitate adjustment of balance of optical characteristics of a film, and at the same time, easily make it possible to suppress curl of a film when an underlying layer is provided to only one surface of a resin substrate.

(Protecting layer)

Important functions of a protecting layer is easing concentration of external stress to a gas barrier layer formed and maintaining gas barrier performance as described above. As a result of intensive studies made by the present invention, physical properties required in a protecting layer as a layer were found to be the same as in an underlying layer.
By setting 0.5 GPa or more of a hardness of a film, deterioration in gas barrier performance due to stress is hardly generated, and by setting 0.5 GPa or less of a hardness of a film, an internal stress generated in a protecting layer to external stress does not become large, and generation of cracks in the protecting layer hardly occurs.
Furthermore, even within the above described range of a hardness, when an elastic modulus recovery ratio is less than 50%, that is, when a ratio of a plastic deformation amount to an entire deformation amount is large, it was found that although a certain effect is exerted for endurance of initial performance, explosive destruction occurs when stress continues for a long time in an acceleration test, and the like.
That is, it is found that a protecting layer is required to have layer physical properties of small plastic deformation (destruction) to external stress added for a long time in combination with diffusing stress from the outside to avoid concentration of the stress to the boundary between the protecting layer and a gas barrier layer.
A material that realizes the above described physical properties is the same as for an underlying layer, the same material as an underlying layer material is possibly used and a material that is different from that of an underlying layer can also be used.
The thickness of the protecting layer in the present invention is preferably 50 nm to 5 μm, and more preferably 300 nm to 1 μm. When the thickness is set to 50 nm or more, the effect of the protecting layer is exerted, and when it is set to 5 μm or less, curl balance and optical performance as a film can be easily adjusted while keeping the effect of the protecting layer.

(Conversion treatment of layer adjacent to gas barrier layer)

As described above, in order to impart physical properties of the present invention to a layer adjacent to a gas barrier layer such as an underlying layer and a protecting layer, a precursor for formation of an adjacent layer (for example, the above descried polysilazane solution) is coated to form a precursor layer, and a conversion treatment (post curing treatment) is then preferably carried out on the precursor layer. As the conversion treatment, it is preferable to perform a post treatment that promotes a three dimensional crosslinking reaction in a layer such as an ultraviolet irradiation treatment and an annealing (heating) treatment as the post curing treatment. An ultraviolet irradiation treatment capable of promoting a reaction without exposing a substrate to a high temperature is more preferable.
In order to form a three dimensional crosslinking structure with an inorganic polymer material, in general, addition of a heat treatment at 200°C or more makes it possible to do so, but film formation on a resin substrate with low heat resistance is difficult. As a result of intensive studies made by the present inventors, a coating film made of these materials is formed on a resin substrate, removal of a solvent and a curing reaction in the initial stage (precuring treatment) by a heat treatment at a heat resistant temperature or less of the resin substrate are carried out, and then irradiated with a high energy line, for example, a vacuum ultraviolet ray at a wavelength of 200 nm or less, thereby making it possible to adjust film physical properties within the range of the present invention without giving damage to the resin substrate.
A drying temperature in the heat treatment at a heat resistant temperature or less of a resin substrate is preferably a high temperature from the viewpoint of a rapid treatment, and the temperature and treatment time are preferably suitably determined in consideration of heat damage given to the resin substrate. For example, when a polyethylene terephthalate substrate having a glass transition temperature (Tg) of 70°C is used as a resin substrate, a heat treatment temperature can be set at 200°C or less. The treatment time is preferably a short time so that a solvent is removed and heat damage to the substrate is less, and can be set within 30 minutes when the drying temperature is 200°C or less.
Furthermore, for the conversion treatment and the ultraviolet irradiation treatment on a layer adjacent to a gas barrier layer, a conversion treatment on a gas barrier layer, which will be described later, can be referred. In addition, a preferable embodiment of the conversion treatment during forming an adjacent layer is also the same as the conversion treatment on a gas barrier layer, which will be described later.

<Gas barrier layer>

Known gas barrier layers can be widely applied to the gas barrier layer according to the present invention. In particular, the present invention especially has a structure excellent in diffusion of film format ion stress of a gas barrier layer and diffusion of external stress. Therefore, the present invention is generally excellent in continuous productivity. Furthermore, a gas barrier layer obtained by a modification treatment on a precursor layer through coating a gas barrier

layer precursor layer is apt to have large condensed stress during film formation, but even with such a gas barrier layer, the gas barrier performance can be significantly improved by using the adjacent layer of the present invention. In addition, a gas barrier layer that is produced in a vapor deposition method typically including a CVD method can also increase a film formation speed.

The gas barrier layer according to the present invention may be a single layer or a plurality of similar layers may be laminated, and gas barrier performance can be also improved with plural layers. The gas barrier layer may be laminated with other materials, for example, materials with water absorbability or reactivity with water may be laminated and arranged as a desiccant layer, or known barrier layers may also be laminated.

In order to impart particularly high gas barrier performance, a gas barrier layer preferably contains a metal oxide, a metal nitride, and a metal oxynitride. This is because these are chemically stable and have precise structures. As metal species of these compounds, it is preferable to select at least one from Si, Al and Ga, each of which has an average interbond distance to an oxide, a nitride, and an oxynitride of about the same or less size of a water molecule (3 to 4 Å). For formation of such a gas barrier layer, a metal oxide, a metal nitride, and a metal oxynitride containing Si, Al, Ga may be formed into a film with a sputter, or the like, or a film is formed by using a precursor compound that contains Si, Al and Ga and converts into a metal oxide, a metal nitride, and a metal oxynitride containing Si, Al and Ga by a conversion treatment, preferable, an ultraviolet irradiation treatment. Examples of such a precursor compound include polysilazane; gallium nitrate; aluminum nitrate; siloxane polymers, which are described in the section of an adjacent layer.

(Underlying layer and protecting layer in laminating gas barrier layer)

The gas barrier layer according to the present invention can be further improved in a gas barrier performance of a gas barrier film by laminating a plurality of layers. For lamination of a gas barrier layer, the first layer of a gas barrier layer is formed and then a laminated layer may be sequentially formed directly on the first layer of the gas barrier layer, or a protecting layer according to the present invention is provided and the second layer of the gas barrier layers may be formed on the protecting layer. When the protecting layer according to the present invention is used (when the protecting layer is an adjacent layer), an adjacent layer becomes an underlying layer for the second layer of the gas barrier layer. In this case, either of conditions for the underlying layer or the protecting layer may be used for conditions such as setting a film thickness, but a gas barrier film is preferably formed under the condition for the protecting layer from the viewpoints that the total film thickness of the gas barrier film is not so large and curl balance can be easily achieved.

(Conversion treatment of gas barrier layer)

In the present invention, a gas barrier layer is preferably formed by carrying out a conversion treatment on a precursor layer formed by coating.

When a precursor layer of a gas barrier layer is coated, any of an organic solvent and an aqueous solvent can be selected as the solvent. As the precursor layer, a metal oxide, metal nitride or metal oxynitride precursor; a solvent; and other additives can be preferably included. Examples of the other additives include cellulose ethers, cellulose esters; e.g., ethylcellulose, nitrocellulose, cellulose acetate, and cellulose acetobutylate, natural resins; e.g., rubbers and rosin resins, synthetic resins; e. g. , polymerized resins, condensed resins; e.g., aminoplast, particularly, urea resins, melamine formaldehyde resins, alkyd resins, acrylic resins, polyesters or modified polyesters, epoxides, polyisocyanates or blocked polyisocyanates, polysiloxane, and surfactants.

In order to stably form a coated film, a surface treatment on a surface to be coated may be carried out. As a method of a surface treatment, a surface can be treated in known surface treatment methods such as a flame treatment, a corona discharge treatment, a glow discharge treatment, an oxygen plasma treatment, a UV ozone treatment, and an excimer light treatment. It is preferable to treat a surface so that a contact angle of a coating liquid is from 10° to 30° by a surface treatment on the substrate surface. When the contact angle is 30° or less, a uniform coated film can be formed and adhesion strength of a gas barrier layer can be maintained. When the angle is 10° or more, a substrate surface hardly deteriorates and adhesion strength of a gas barrier layer can be maintained.

In a treatment of converting a metal oxide, metal nitride or metal oxynitride precursor layer according to the present invention into a metal oxide, a metal nitride, or a metal oxynitride, a heat and/or ultraviolet irradiation treatment, particularly, a deep ultraviolet ray or a vacuum ultraviolet ray at a wavelength of an ultraviolet ray of 300 nm or less is preferably used. A heating temperature may be suitably selected between 50 to 300°C, and the highest temperature by a DSC analysis of a raw material, that is, a temperature higher than a temperature at which desorption of crystal water and formation of an oxide, a nitride or an oxynitride are initiated is more preferably selected. When the temperature is 50°C or less, progress of a reaction is very slow, and an oxide, a nitride or an oxynitride cannot be formed in a short time, and when it is 300°C or more, deformation of a substrate itself and cracks caused by deformation of a substrate, or layer peeling may be generated due to a problem of heat resistance of a resin substrate. A resin substrate can be

suitably selected in view of desorption of crystal water of a metal salt raw material/a temperature in a reaction of forming an oxide, a nitride or an oxynitride and a process temperature in a step of manufacturing other devices. A time for a heat treatment can be suitable selected, and is preferably 0.1 to 10 minutes, and more preferably 1 to 5 minutes from the viewpoint of productivity.

(Ultraviolet ray irradiation treatment)

For the conversion treatment, an ultraviolet ray irradiation treatment at 400 nm or less is preferably carried out, and a vacuum ultraviolet ray at a wavelength of an ultraviolet ray of 200 nm or less is particularly preferably used. A mechanism of improvement in gas barrier performance due to ultraviolet ray irradiation is not revealed, but because an ultraviolet ray with high photon energy is effective, ultraviolet ray irradiation is supposed to assist desorption of crystal water and a reaction of formation of an oxide, a nitride or an oxynitride. Since a vacuum ultraviolet ray particularly has photon energy capable of cutting a bond and promoting recombination, and shows high water absorption, ultraviolet ray irradiation is supposed to more effectively assist desorption of crystal water and a reaction of formation of an oxide, a nitride or an oxynitride. Irradiation energy of an ultraviolet ray is preferable within the range from 10 to 10,000 $mJ/cm^2$ and more preferably from 100 to 5,000 $mJ/cm^2$. When the irradiation energy is within this range, the effect of ultraviolet ray irradiation can be appropriately obtained, and damage to a resin substrate is less.

(Vacuum ultraviolet ray irradiation treatment; excimer irradiation treatment)

In the present invention, an example of a more preferable method of a modification treatment includes a treatment by vacuum ultraviolet ray irradiation. In a treatment by vacuum ultraviolet ray irradiation, vacuum ultraviolet ray irradiation is supposed to assist decomposition and removal of contained organic substances, removal of moisture in a film, formation of an oxide using light energy with a wavelength from 100 to 200 nm, preferably using photon energy with a wavelength from 100 to 180 nm. The treatment by vacuum ultraviolet ray irradiation is a method of carrying out formation of a thin film of a metal oxide, a metal nitride or a metal oxynitride at a relatively low temperature by progressing an oxidation reaction by active oxygen, ozone, and the like while directly cutting an interatomic bond due to an action of cutting and recombination of an interatomic bond only by photon, which is called a photon process. In addition, the treatment by vacuum ultraviolet ray irradiation photon is supposed to be able to effectively decompose and remove an organic substance taken in as an impurity since a photon energy is larger than most of organic substance bond energy, and further, effectively remove crystal water in a film, which is hardly removed only by heating since water also has strong abruption in an vacuum ultraviolet region. Note that combination use of heating without damaging a resin substrate makes these effects further enhanced. Examples of a heat treatment include a method of heating a coated film with heat conduction by bringing a heat generator such as a heat block into contact with a substrate, a method of heating an atmosphere by an external heater with resistance wire, or the like, and a method using a light in an infra-red region such as an IR heater, without particularly limitation. A heating temperature is preferably suitably set within the range from 50°C to 250°C. A heating time is preferably within the range from 1 second to 10 hours.

A noble gas excimer lamp is preferably used as a vacuum ultraviolet light source.

Excimer emission is called an inactive gas since atoms of noble gases such as Xe, Kr, Ar and Ne do not chemically bond to form molecules. However, an atom of a noble gas (excited atom) that obtains energy from discharge, or the like can form a molecule by bonding with another atom. When a noble gas is xenon,

$$e + Xe \rightarrow e + Xe^*$$

$$Xe^* + Xe + Xe \rightarrow Xe_2^* + Xe$$

are formed, and when $Xe_2^*$ that is an excited excimer molecule is transferred into a base state, it emits excimer light at 172 nm. As an example of characteristics of an excimer lamp, irradiation is concentrated on one wavelength and almost no light except for necessary light is radiated, thus being highly effective.

In addition, since excessive light is not radiated, a temperature of an object can be kept low. Furthermore, since a time for start-up and restart is not required, immediate lighting and blinking are possible.

In order to obtain excimer emission, a method of using a dielectric material barrier discharge has been known. The dielectric material barrier discharge is discharge called very thin micro discharge similar to lightning, which is generated in a gas space by arranging a gas space through a dielectric material (transparent quartz in the case of an excimer lamp) between the both electrodes and applying a high-frequency high voltage at several tens kHz to the electrodes. When a streamer of micro discharge reaches a tube wall (dielectric material), charges is accumulated in the surface of the dielectric material and micro discharge thus disappears. This micro discharge is discharge that spreads to the entire tube wall and repeats generation and disappearance. Therefore, light flickering recognized with the naked

eye is generated. In addition, since a streamer at a very high temperature locally directly reaches the tube wall, there is a possibility to accelerate deterioration of the tube wall.

As a method of effectively obtaining excimer emission, in addition to dielectric material barrier discharge, electrodeless field discharge is also possible.

Electrodeless field discharge by a capacitive bond is also called by the other name, RF discharge. A lamp, electrodes, and the arrangement may be basically the same as dielectric material barrier discharge, but a high frequency applied between the both electrodes is lightened at several MHz. Since such spatially and temporally uniform discharge can be obtained from electrodeless field discharge, a long-lived lamp without flickering is obtained.

In the case of dielectric material barrier discharge, micro discharge is generated only between the electrodes, and thus, the electrode in the outside should cover the whole external surface and transmit light for extracting light to the outside in order to discharge with the entire discharge space. Therefore, an electrode obtained by forming a thin metal wire into a net is used. Since this electrode uses a wire as thin as possible so as not to block light, it is easily damaged by ozone, and the like, which are generated due to a vacuum ultraviolet light in an oxygen atmosphere.

In order to avoid the damage, there is a need to extract irradiation light by making a periphery of a lamp, that is, the inside of an irradiation device be an inert gas atmosphere and providing a window of synthetic quarts. The window of synthetic quarts is not only an expensive consumable but also causes loss of light.

Since a double cylindrical lamp has an external diameter of about 25 mm, a gap of distances to irradiated surfaces immediately below the lamp shaft and on the lamp side cannot be ignored, and a significant gap in illuminance is generated. Therefore, even if a lamp is closely arrayed, uniform irradiation distribution is not obtained. A use of an irradiation device provided with a window of synthetic quarts makes it possible to have uniform distances in an oxygen atmosphere and uniform irradiation distribution can be obtained.

When electrodeless field discharge is used, an external electrode is not necessarily in a net form. Only by providing an external electrode in a part of a lamp external surface, glow discharge spreads to the whole discharge space. For the external electrode, an electrode that doubles as a light reflecting plate made of a general aluminum block is used in the back side of the lamp. However, since an external diameter of a lamp is large in the same manner as the case of dielectric material barrier discharge, synthetic quarts is necessary in order to obtain uniform illuminance distribution.

The most significant characteristic of a fine tube excimer lamp is having a simple structure. A fine tube excimer lamp only encapsulates a gas by closing the both sides of a quartz tube for performing excimer light emission inside the quartz tube. Therefore, a very inexpensive light source can be provided.

Since a double cylindrical lamp has undergone a process of connecting the both ends of internal and external tubes to close, it is easily damaged in handling and transportation as compared to a fine tube lamp. An external diameter of a tube of a fine tube lamp is from about 6 to 12 mm, and when it is too thick, a high voltage is necessary for start-up.

Both of dielectric material barrier discharge and electrodeless field discharge can be used for a discharge form. As a shape of an electrode, a surface contacting with a lamp may be a flat surface, but when the surface is formed into a shape conformed to a curved surface of a lamp, the lamp can be fixed firmly and discharge is more stable due to closely attaching the electrode to the lamp. In addition, when a curved surface is made a mirror surface with aluminum, it is also used as a reflecting plate.

An excimer lamp emits an ultraviolet ray with a short wavelength of 172 nm by a single wavelength and therefore is excellent in emission efficiency. Since this light has a large oxygen absorption coefficient, it can generate radical oxygen atom species and ozone at high concentrations with a very small amount of oxygen. Furthermore, light energy with a short wavelength of 172 nm, which dissociates a bond of an organic substance, has been known to have high ability. Modification of a polysilazane film can be realized in a short time by this active oxygen, ozone and high energy of ultraviolet irradiation. Therefore, an excimer lamp enables shortening of a process time accompanied by high throughput, reduction of a facility area and irradiation to an organic material, or a plastic substrate, and the like, which easily receive damages due to heat, as compared to a low pressure mercury lamp and plasma washing, which emit wavelengths of 185 nm and 254 nm.

An excimer lamp has high light generation efficiency and thus makes it possible to lighten with low electrical power input. In addition, an excimer lamp does not emit light with a long wavelength, which is a cause of temperature increase by light, and radiates energy with a single wavelength in an ultraviolet ray region, and thus, has a characteristic of suppressing increase of a surface temperature of an object to be irradiated. Therefore, an excimer lamp is suitable for a flexible film material such as PET, which is known to be easily affected by heat.

(Gas barrier layer using vapor deposition method)

For the gas barrier film according to the present invention, a gas barrier layer formed by a known vapor deposition method can also be used. Vapor deposition methods are roughly divided into physical vapor deposition methods and chemical vapor deposition methods, and the physical vapor deposition method is a method of depositing a thin film of

a desired substance (silicon oxide in this case) on a surface of a substance in a gas phase by a physical technique, and examples of the method include vapor deposition (resistance heating method, electron beam deposition, and molecular beam epitaxy) methods, or anion plating method and a sputter method, any method may be used, but among these methods, a sputter method that is easily applied also to a material with a high melting point, or the like is preferable to form a ceramic layer containing silicon oxide.

In the sputter method, a target is arranged in a vacuum chamber, an ionized noble gas element (usually, argon) obtained by applying a high voltage is allowed to collide with the target and atoms in the target surface are sputtered to thus attach to a substrate. In this case, a reactive sputtering method in which, by flowing a nitrogen gas or an oxygen gas in a chamber, an element sputtered from the target by an argon gas is reacted with nitrogen and oxygen to thus form a gas barrier layer may also be used.

In addition, a chemical vapor deposition method is a method of supplying a raw material gas containing components of a desired thin film on a substrate and depositing a film by a chemical reaction in the substrate surface or a gas phase, and also includes a method of generating plasma, or the like, for the purpose of activating a chemical reaction.

These chemical vapor deposition methods include a heat CVD method, a plasma CVD (vacuum, atmospheric pressure) method, etc., which can easily form different ceramic layers by change and adjustment of a raw material gas, and among these methods, an atmospheric pressure plasma (atmospheric pressure PECVD) method having a high film formation speed is a particularly preferable method.

Among atmospheric pressure plasma methods, a so-called dual frequency atmospheric pressure plasma method in which two or more electric fields having different frequencies are applied is particularly preferable, and the method will be specifically described later.

For a raw material gas used in chemical vapor deposition method, a raw material gas that becomes a desired gas barrier layer may be suitably selected, and examples thereof include metal compounds such as a silicon compound, a titanium compound, a zirconium compound, an aluminum compound, a boron compound, a tin compound, and an organic metal compound. Among these substances, examples of the silicon compound include silane, tetramethoxysilane, tetraethoxysilane, tetra n-propoxysilane, tetraisopropoxysilane, tetra n-buthoxysilane, tetra t-buthoxysilane, dimethyldimethoxysilane, dimethyldiethoxysilane, diethyldimethoxysilane, diphenyldimethoxysilane, methyltriethoxysilane, ethyltrimethoxysilane, phenyltriethoxysilane, (3,3,3-trifluoropropyl)trimethoxysilane, hexamethyldisiloxane, bis(dimethylamino)dimethylsilane, bis(dimethylamino)methylvinylsilane, bis(ethylamino)dimethylsilane, N,O-bis(trimethylsilyl)acetoamide, bis(trimethylsilyl)carbodiimide, diethylaminotrimethylsilane, dimethylaminodimethylsilane, hexamethyldisilazane, hexamethylcyclotrisilazane, heptamethyldisilazane, nonamethyltrisilazane, octamethylcyclotetrasilazane, tetrakisdimethylaminosilane, tetraisocyanatesilane, tetramethyldisilazane, tris(dimethylamino)silane, triethoxyfluorosilane, allyldimethylsilane, allyltrimethylsilane, benzyltrimethylsilane, bis(trimethylsilyl)acetylene, 1,4-bistrimethylsilyl-1,3-butadiyne, di-t-butylsilane, 1,3-disilabutane, bis(trimethylsilyl)methane, cyclopentadienyltrimethylsilane, phenyldimethylsilane, phenyltrimethylsilane, propargyltrimethylsilane, tetramethylsilane, trimethylsilylacetylene, 1-(trimethylsilyl)-1-propyne, tris(trimethylsilyl)methane, tris(trimethylsilyl)silane, vinyltrimethylsilane, hexamethyldisilane, octamethylcyclotetrasiloxane, tetramethylcyclotetrasiloxane, hexamethylcyclotetrasiloxane, and M silicate 51. Examples of the aluminum compound include aluminum ethoxide, aluminum triisopropoxide, aluminum isopropoxide, aluminum n-buthoxide, aluminum s-buthoxide, aluminum t-buthoxide, aluminum acetylacetonate, and triethyl dialuminum tri-s-buthoxide.

(Dual frequency atmospheric pressure plasma method)

Atmospheric pressure plasma methods are described in, for example, Japanese Patent Laid-Open No. 10-154598 and Japanese Patent Laid-Open No. 2003-49272, WO No. 02/048428, etc., in particular, a thin film formation method described in Japanese Patent Laid-Open No. 2004-68143 is preferable for forming a ceramic layer with precision and high gas barrier performance. Furthermore, a web-form substrate is unreeled from a rolled core column and a ceramic layer with different compositions can be continuously formed.

The above described atmospheric pressure plasma method according to the present invention is a plasma CVD method carried out under atmospheric pressure or a pressure around the atmospheric pressure, the atmospheric pressure or a pressure around the atmospheric pressure is about 20 to 110 kPa, and in order to obtain preferable effect described in the invention, it is preferably 93 to 104 kPa.

As the discharge conditions of the present invention, two or more electric fields with different frequencies are preferably applied in a discharge space, and the first high-frequency electrical field and the second high-frequency electrical field are overlapped and electric fields are applied.

The frequency $\omega 2$ of the second high-frequency electrical field is higher than the frequency $\omega 1$ of the first high-frequency electrical field, and a relationship among the intensity V1 of the first high-frequency electrical field, the intensity V2 of the second high-frequency electrical field, and the intensity IV of a discharge initiation electric field satisfies $V1 \geq IV > V2$, or $V1 > IV \geq V2$, and the output density of the second high-frequency electrical field is 1 $W/cm^2$ or more.

A high frequency refers to a frequency of at least 0.5 kHz or more.

When both of the overlapped high-frequency electrical fields are sine curves, a compound obtained by overlapping the frequency ω1 of the first high-frequency electrical field and frequency ω2 of the second high-frequency electrical field higher than the frequency ω1 is formed, and the waveform is a sawtooth form of overlapping the sine curve with the frequency ω2 higher than the frequency ω1 on the sine curve with the frequency ω1.

In the present invention, the intensity of the discharge initiation electric field indicates the minimum electric field intensity which can cause discharge in a discharge space (constitutions of electrodes, etc.) and reaction conditions (gas condition, etc.), which are used in an actual film formation method. The discharge initiation electric field intensity fluctuates in some degrees by a gas species supplied in a discharge space, a dielectric material species of electrodes, or distance between the electrodes, but it is controlled by a discharge initiation electric field intensity of a discharge gas in the same discharge space.

A high-frequency electrical field as described in the above description is applied to a discharge space, thereby causing discharge capable of forming a thin film, and it is assumed to be able to generate high density plasma necessary for formation of a high-grade thin film.

What is important herein is to apply such a high-frequency electrical field to a space between electrodes facing each other, that is, to apply to the same discharge space. As described in Japanese Patent Laid-Open No. 11-16696, a method of placing two applied electrodes side by side and applying different high-frequency electrical fields to each of different divided discharge spaces is not preferable.

Overlapping continuous waves such as a sine curve was explained in the above description but is not limited thereto, and both waves may be pulse waves, or one may be a continuous wave and the other may be a pulse wave. In addition, a high-frequency electrical field may also have the third electric field having a different frequency.

An example of a specific method of applying the above described high-frequency electrical field to the same discharge space includes using an atmospheric pressure plasma discharge treatment device of connecting the first power supply that applies the first high-frequency electrical field having a frequency ω1 and an electric field intensity V1 with the first electrode constituting a facing electrode, and connecting the second power supply that applies the second high-frequency electrical field having a frequency ω2 and an electric field intensity V2 with the second electrode.

The above described atmospheric pressure plasma discharge treatment device is provided with a gas supply means for supplying a discharge gas and a thin film formation gas (raw material gas) between the electrodes facing each other. Furthermore, the device preferably also has an electrode temperature control means for controlling a temperature of an electrode.

In addition, the first filter is preferably connected with either the first electrode, the first power supply or a place between them, and the second filter is preferably connected with either the second electrode, the second power supply or a place between them, the first filter easily allows passing through a current of the first high-frequency electrical field from the first power supply to the first electrode, and hardly allows passing through a current of the second high-frequency electrical field from the second power supply to the first power supply by grounding the current of the second high-frequency electrical field. In addition, the second filter, on the contrary, has a function that easily allows passing through a current of the second high-frequency electrical field from the second power supply to the second electrode, and hardly allows passing through a current of the first high-frequency electrical field from the first power supply to the second power supply by grounding the current of the first high-frequency electrical field and such a filter is used. Herein, "hardly allow(s) passing through" means that preferably 20% or less of a current, more preferably 10% or less of a current is only allowed to pass through. On the other hand, easily passing through means that preferably 80% or more of a current, more preferably 90% or more of a current is allowed to pass though.

For example, as the first filter, a condenser with several 10 pF to several tens of thousands pF or a coil with about several μH can be used according to a frequency of the second power supply. As the second filter, a coil with 10 μH or more is used according to a frequency of the first power supply, and grounding is performed through such a coil and a condenser, thereby being able to be used as a filter.

Furthermore, the first power supply in the atmospheric pressure plasma discharge treatment device of the present invention preferably has an ability of applying an electric field intensity higher than the second power supply.

An applied electric field intensity and a discharge initiation electric field intensity are measured in the method described below.

Method of measuring applied electric field intensities V1 and V2 (unit: kV/mm) : A high frequency voltage probe (P6015A) is arranged in each electrode part, an input signal of the high frequency voltage probe is connected with an oscilloscope (TDS3012B, manufactured by Tektronix, Inc.) to measure an electric field intensity at a predetermined point of time.

Method for measuring discharge initiation electric field intensity IV (unit: kV/mm) : A discharge gas is supplied between electrodes, the electric field intensity between the electrodes is increased, and an electric field intensity at which discharge is started is defined to be a discharge initiation electric field intensity IV. A measurement apparatus is the same as used in the above describedmeasurement of an applied electric field intensity.

By adopting the discharge conditions as described above, even with a discharge gas having a high discharge

initiation electric field intensity such as a nitrogen gas, discharge can be initiated, a stable plasma state with a high density can be kept, and thin film formation having high performance can be carried out.

When a discharge gas is a nitrogen gas by the above described measurement, the discharge initiation electric field intensity IV (1/2Vp-p) is about 3. 7 kV/mm, and therefore, in the above described relationship, the first applied electric field intensity is applied as $V1 \geq 3.7$ kV/mm, thereby exciting a nitrogen gas and making it possible to be in a plasma state.

Herein, a frequency of the first power supply of 200 kHz or less is preferably used. The waveform of this electric field may be a continuous wave or a pulse wave. The lower limit is desirably about 1 kHz.

On the other hand, a frequency of the second power supply of 800 kHz or more is preferably used. Higher the frequency of the second power supply is, larger the plasma density is, and a precise and high quality thin film can be obtained. The upper limit is desirably about 200 MHz.

Application of high-frequency electrical fields from such two power supplies is necessary for initiating discharge of a discharge gas having a high discharge initiation electric field intensity by the first high-frequency electrical field, and a plasma density is preferably increased by a high frequency and a high output density of the second high-frequency electrical field to form a precise and high quality thin film.

In addition, by increasing an output density of the first high-frequency electrical field, an output density of the second high-frequency electrical field can be improved while keeping uniformity of discharge. Accordingly, further more uniform high density plasma can be generated and further improvement in a film formation speed and improvement in film quality are compatibly achieved.

(Thickness of gas barrier layer)

The thickness of the gas barrier layer according to the present invention is preferably 1 to 100 nm per one layer, and more preferably 10 to 50 nm. When the thickness is within such a range, barrier performance is exerted and cracks are hardly generated in the gas barrier layer. An example of a method of compatibly achieving improvement in gas barrier performance and prevention of cracks includes a method of segmentalizing layers with a total film thickness being constant. Residual stress during formation of a metal oxide can be reduced and, even in the case of combining the gas barrier layer according to the present invention with an adjacent layer thereof to be highly modified, cracks can be suppressed. In addition, sequential lamination of gas barrier layers enables shifting a defect position, and gas barrier performance is further improved due to the roundabout effect. The number of layers in this case is preferably from about 2 to 4 layers.

(Surface roughness: surface smoothness)

A surf ace roughness (Ra) in the surf ace of the gas barrier film according to the present invention is preferably 2 or less, and more preferably 1 or less. The surface roughness within this range is preferable because, when used as a resin substrate of each electron device, light transmission efficiency is improved by a smooth film surface with less unevenness and energy conversion efficiency is improved by reduction of a leak current between electrodes. The surface roughness (Ra) in the surf ace of the gas barrier film according to the present invention can be measured in the following method.

Method of measuring surface roughness; AFM measurement, the surface roughness is a roughness relating to amplitude of fine unevenness obtained by calculating from a profile curve of unevenness continuously measured with a detection device having a sensing pin with a tiny tip radius by AFM (atomic force microscope), for example, DI3100 manufactured by DigitalInstrumentsCorporation,and carrying out measurements in a zone of several tens μm in a measurement direction by the sensing pin with a tiny tip radius many times.

<Constitution of gas barrier film>

(Substrate (resin substrate): support)

A substrate (also called "support") of the gas barrier film of the present invention is not particularly limited as long as it is a material capable of retaining a gas barrier layer having barrier performance that will be described later, and a resin substrate formed from an organic material is used because of continuous production by roll-to-roll, lightening of a device, and prevention of cracks.

Examples of a resin substrate film include respective resin films of an acrylic acid ester, a methacrylic acid ester, polyethylene terephthalate (PET), polybutylene terephthalate, polyethylene naphthalate (PEN), polycarbonate (PC), polyarylate, polyvinyl chloride (PVC), polyethylene (PE), polypropylene (PP), polystyrene (PS), nylon (Ny), aromatic polyamide, polyether ether ketone, polysulfone, polyethersulfone, polyimide, polyetherimide, and the like, heat resistant

transparent films containing silsesquioxane having an organic inorganic hybrid structure as the base skeleton (trade name: Sila-DEC, manufactured by Chisso Corporation), and further, resin films obtained by laminating two or more of the above described resins. From the viewpoints of a cost and a easiness of availability, polyethylene terephthalate (PET), polybutylene terephthalate, polyethylene naphthalate (PEN), polycarbonate (PC), and the like are preferably used, and from the viewpoints of optical transparency, heat resistance, adhesivity to an inorganic layer and a gas barrier layer, heat resistant transparent films containing silsesquioxane having an organic inorganic hybrid structure as the base skeleton can be preferably used. A thickness of a support is preferably from about 5 to 500 μm, and more preferably from about 25 to 250 μm.

In addition, a support according to the present invention is preferably transparent. This is because, by making the support transparent and also making a layer formed on the support transparent, a transparent gas barrier film can be formed and thus used as a transparent substrate of an organic EL element, and the like.

A support using the above described resins may be an unstretched film or a stretched film.

A support used in the present invention can be produced by a conventionally known general method. For example, a resin being a material is molten by an extruder, extruded by a circular die or a T die to be rapidly cooled, thereby enabling production of an unstretched support that is substantially amorphous and not oriented. Further, the unstretched support is stretched in the flow (vertical) direction of the support or the perpendicular (lateral) direction to the flow direction of the support in known methods such as uniaxial stretching, tenter method sequential biaxial stretching, tenter method simultaneous biaxial stretching, tubular method simultaneous biaxial stretching, thereby making it possible to produce a stretched support. A draw ratio in this case can be suitably selected according to a resin being a raw material of a support, and each draw ratio of the vertical direction and the lateral direction is preferably 2 to 10 times.

In addition, a corona treatment, and the like can be performed on the support according to the present invention before forming an underlying layer.

An anchor coating agent layer may be formed on the surface of the support according to the present invention for the purpose of improvement in adhesivity to an underlying layer or a gas barrier layer. For an anchor coating agent used in the anchor coating agent layer, one, or two or more of combination of a polyester resin, an isocyanate resin, an urethane resin, an acrylic resin, an ethylene vinyl alcohol resin, a vinyl modified resin, an epoxy resin, a modified styrene resin, a modified silicon resin, and alkyl titanate, and the like can be used. Conventionally known additives can be also added to these anchor coating agents. Then, the above described anchor coating agent is coated on a support in a known method such as roll coating, gravure coating, knife coating, dip coating, and spray coating, and a solvent, a diluent, and the like are removed by drying, thereby enabling anchor coating. A coating amount of the above described anchor coating agent is preferably about 0.1 to 5 $g/m^2$ (dry state).

(Measurement method of surface hardness and elastic modulus recovery ratio; nanoindentation)

A hardness and an elastic modulus recovery ratio of an adjacent layer are measured by a nanoindenter in the present invention from the viewpoint that a surface hardness and an elastic modulus recovery ratio of an adjacent layer of a very thin gas barrier layer can be measured with high accuracy.

Herein, "the nanoindentation method" means a method in which a load is given to a gas barrier layer being an object to be measured, which is provided on a resin substrate, by pressing a triangular pyramid penetrator having a tip radius of about 0.1 to 1 μm with a very small load, the penetrator is then returned to remove the load, the obtained load-displacement curve is formed, and a surface hardness, an elastic modulus and an elastic modulus recovery ratio are thus measured from a given load and a press depth obtained from the load-displacement curve. In this nanoindentation method, a measurement can be carried out at a high accuracy of 0.01 nm as a displacement resolution, using a head assembly with a very low load, for example, the maximum load of 20 μN and a load resolution of 1 nN.

Fig. 1 shows a typical load-displacement curve in the case of measuring a thin film by nanoindentation. A surface hardness in the present invention is calculated from a load at the maximum displacement as described above in consideration of a shape of a penetrator, and an elastic modulus recovery ratio is defined as a ratio of a gap between the maximum displacement magnitude and a displacement magnitude at which a load is 0 when a penetrator is returned from the maximum displacement magnitude.

(Evaluation of water vapor transmission ratio)

A water vapor transmission ratio of the gas barrier film of the present invention can be evaluated by the following measurement method.

<Devices>

Deposition apparatus: Vacuum deposition apparatus JEE-400 manufactured by JEOL Ltd.
Constant temperature and humidity oven: Yamato Humidic
Chamber IG47M laser microscope: KEYENCE VK-8500

<Raw materials>

Metal corroded by reaction with moisture: calcium (granulated)

Water vapor impermeable metal: aluminum ϕ3 to 5 mm, granulated)

<Preparation of cell for water vapor barrier performance evaluation>

Metal calcium is deposited on a gas barrier layer surface of a barrier film sample in an area of 1 cm × 1 cm with a mask using a vacuum deposition apparatus (JEE-400 manufactured by JEOL Ltd.). Then, the mask is removed with keeping a vacuum state, and aluminum is deposited on the whole surface of one side of the sheet from the other metal deposition source. After sealing with aluminum, the vacuum state is released and a quartz glass with a thickness of 0.2 mm is rapidly faced with the aluminum sealing side through a sealing ultraviolet ray curable resin (manufactured by Nagase Chemtex Corporation) under a dry nitrogen gas atmosphere and irradiated with an ultraviolet ray to thus prepare a cell for evaluation.
The obtained sample having the both surfaces sealed is preserved under a high temperature and a high humidity of 60°C and 90%RH, and a moisture content that permeates into a cell is calculated from a corrosion amount of metal calcium based on the method described in Japanese Patent Laid-Open No. 2005-283561.
In order to confirm no permeation of water vapor except for water vapor from a barrier film surface, a sample deposited with metal calcium using a quartz glass plate with a thickness of 0.2 mm is preserved under a high temperature and a high humidity of 60°C and 90%RH in the same manner in place of a barrier film sample as a comparative sample, and no generation of corrosion in the metal calcium even after lapse of the time for 1,000 hours is confirmed.

<Application>

A gas barrier film can be preferably used in a device that deteriorates performance by chemical components in the atmosphere (such as oxygen, water, nitrogen oxide, sulfur oxide, and ozone). Examples of the device include electron devices such as an organic EL element, a liquid crystal display element, a thin film transistor, atouchpanel, electronpaper, and a solar battery), and the gas barrier film is preferably used in an organic EL element.
The gas barrier film can also be used for film seal of a device. That is, it is a method of using a device itself as a support and providing the gas barrier film of the present invention on the surface of the device. A device may be covered with a protecting layer before providing the gas barrier film.
The gas barrier film of the present invention can also be used as a substrate of a device and a film for sealing by a solid sealing method. The solid sealing method is a method of laminating and curing an adhesive layer and a gas barrier film after forming a protecting layer on a device. An adhesive agent is not particularly limited, and examples thereof include a thermosetting epoxy resin and a photocurable acrylate resin.

Examples

The present invention will be more specifically described in view of examples in the following, but is not limited thereto.

Example 1

(Underlying layer physical properties and gas barrier performance)

<Preparation of gas barrier film>

(Resin substrate: support)

A polyester film with a thickness of 125 μm, which was processed to have easy adhesion on both sides (A4300, manufactured by TOYOBO CO., LTD.) was used as a resin substrate (support).

(Formation of bleed-out prevention layer)

A UV curable organic/inorganic hybrid hard coating material manufactured by JSR Corporation, OPSTAR Z7501, was coated on one side surface of the above described support with a wire bar so as to have a film thickness of 4 μm after drying, and cured in curing conditions; under 1.0 J/cm$^2$ atmosphere, by use of a high pressure mercury lamp and dry conditions; 80°C for 3 minutes to form a bleed-out prevention layer. A bleed-out prevention layer was common in all of the gas barrier films 1 to 18.

(Preparation of substrate 1)

Subsequently, a UV curable organic/inorganic hybrid hard coating material manufactured by JSR Corporation, OPSTAR Z7501, was coated on the opposite side surface (surf ace without having a bleed-out prevention layer) of the above described support with a wire bar so as to have a film thickness of 4 μm after drying, then dried in dry conditions at 80°C for 3 minutes, thereafter curing under the air atmosphere by use of a high pressure mercury lamp in a curing condition; 1.0 J/cm$^2$ to form an underlying layer doubled with a smoothing layer, and a substrate 1 was prepared.

The maximum cross-section height Rt(p) in this process was 16 nm.

The surface roughness was calculated from a profile curve of unevenness continuously measured with a detection device having a sensing pin with a tiny tip radius by AFM (atomic force microscope) and measurements were carried out in a zone of 30 μm in a measurement direction by the sensing pin with a tiny tip radius many times. The surface roughness is a mean roughness relating to amplitude of fine unevenness.

(Preparation of substrate 2)

A titanium oxide oligomer rust inhibitor, Orgatix PC685 manufactured by Matsumoto Trading Co., Ltd. was coated on an underlying layer of the substrate 1 and dried at 80°C for 3 minutes to form a titanium oxide thin film with a dried film thickness of 300 nm. Further, Xe excimer light (wavelength of 172 nm) irradiated the thin film at 1 J/cm$^2$ at a substrate temperature of 100°C to thus obtain a substrate 2. The maximum cross-section height Rt(p) of the substrate 2 was 20 nm.

(Preparation of substrate 3)

The substrate 3 was obtained in the same manner as the substrate 1 except for using a polysiloxane/acrylic resin hybrid coating material, Glassca HPC7506 manufactured by JSR CORPORATION as OPSTAR Z7501 in the substrate 1 and setting the dry conditions of 80°C for 10 minutes. The maximum cross-section height Rt (p) of the substrate 3 was 21 nm. Note that HPC406H manufactured by JSR CORPORATION was added to HPC7506 in an amount of 10% by mass as a curing agent.

(Preparation of substrate 4)

Polysiloxane hard coating material, Glassca HPC7003 manufactured by JSR CORPORATION was coated on the opposite surface (surface without having a bleed-out prevention layer) of the above described support with a wire bar so as to have a film thickness of 4 μm after drying, then dried in the dry conditions at 80°C for 3 minutes, thereafter irradiating the film with Xe excimer light (wavelength of 172 nm) at 1 J/cm$^2$ at a substrate temperature of 100°C to form an underlying layer doubled with a smoothing layer, and a substrate 4 was thus prepared. The maximum cross-section height Rt(p) of the substrate 4 was 18 nm. Note that HPC404H manufactured by JSR CORPORATION was added to HPC7003 in an amount of 10% by mass as a curing agent.

(Preparation of substrate 5)

A polysilazane-based hard coating material, AQUAMICA NAX120-10 (dibutyl ether solution containing 10% by mass of perhydropolysilazane, amine catalyst type, 5% by mass of an amine catalyst with respect to polysilazane) manufactured by AZ Electronic Materials Co. was coated on the underlying layer of the substrate 1 and left for 3 days in an environment at 25°C, 55%RH, to thus obtain a substrate 5 containing a polysilazane layer with a dry film thickness of 300 nm. The maximum cross-section height Rt(p) of the substrate 5 was 12 nm.

(Preparation of substrate 6)

An organic inorganic nanocomposite hard coating material, SSG coat HB21B manufactured by NITTO BOSEKI

CO., LTD. was coated on the opposite surface (surface without having a bleed-out prevention layer) of the above described support with a wire bar so as to have a film thickness of 4 μm after drying, then dried at 120°C for 2 minutes, thereafter leaving for 3 days in an environment at 25°C, 55%RH, to thus obtain a substrate 6. The maximum cross-section height Rt (p) of the substrate 3 was 18 nm.

<Preparation of gas barrier films 1-1 to 1-6>

Gas barrier layers made of silicon oxide, which have film thicknesses of 30 nm, were formed on the substrates 1 to 6 in the conditions shown below using the atmospheric pressure plasma CVD method to thus obtain gas barrier films 1-1 to 1-6.

(Film formation conditions of gas barrier layers>

Discharge gas: nitrogen gas, 94.9% by volume
Thin film forming gas: tetraethoxysilane, 0.1% by volume
Added gas: oxygen gas, 5.0% by volume
The first electrode side
Power supply species Hayden Laboratories, 100 MHz (continuous mode)
PHF-6k
Frequency 100 kHz
Output density 10 W/cm$^2$
Electrode temperature 120°C
The second electrode side
Power supply species Pearl Kogyo Co., Ltd., 13.56 MHz
CF-5000-13M
Frequency 13.56 MHz
Output density 10 W/cm$^2$
Electrode temperature 90°C

<Preparation of gas barrier films 1-7 to 1-12>

A polysilazane solution containing 1% by mass of a catalyst (prepared by mixing NAX120-20 and NN120-20 at 1 : 4) was coated on the substrates 1 to 6 and dried at 80°C for 2 minutes to form polysilazane layers with film thicknesses after drying of 50 nm. Xe excimer light irradiated the polysilazane layers in the conditions shown below and converted, thereby forming gas barrier layers containing silicon oxide (film thickness of 150 nm) to thus obtain gas barrier films 1-7 to 1-12.

(Excimer light irradiation conditions)

Irradiation device: MEIRH-M-1-200H manufactured by
M.D.Excimer, Inc.
Substrate temperature: 100°C
Accumulated light amount: 3 J/cm$^2$
Maximum illuminance: 100 mW/cm$^2$

<Preparations of gas barrier films 1-13 to 1-18>

A conversion treatment was carried out on the substrates 1 to 6 at a substrate temperature of 100°C, an accumulated light amount of 3 J/cm$^2$ by use of the above same device after drying at 150°C for 2 minutes using the following Ga oxide precursor coating liquid, and gas barrier layers containing Ga oxide with film thicknesses of 50 nm were formed to thus obtain gas barrier films 1-13 to 1-18.

Note that, since the aqueous coating liquid described below has very poor coating property for the substrate 3, a polysilazane (NAX120) layer was formed to have a dry film thickness of 30 nmto forma coatingproperty improved layer. The Nanoindentation data is data in the case of no coating property improved layer.

(Ga oxide precursor coating liquid)

Commercially available gallium nitrate nonahydrate (manufactured by Sigma Aldorich, 99.999%) was used and 10% by mass of the gallium nitrate nonahydrate by Ga nitrate conversion was added to ultrapure water, the mixture was stirred for 10 minutes, and then dissolved with ultrasonic waves (48 Hz) for 10 minutes to obtain a Ga nitrate-containing aqueous solution. Surfynol 465 (manufactured by Nissin Chemical Industry Co. , Ltd.) was added to the aqueous solution as a surfactant in an amount of 0.2% by mass with respect to Ga nitrate and deaerated with reduced pressure to thus obtain a Ga nitrate-containing precursor coating liquid.

<Measurement and evaluation of gas barrier film>

As for each of the prepared gas barrier films, a hardness and an elastic modulus recovery ratio of an underlying layer, and a water vapor transmission ratio of a gas barrier film were evaluated in the following methods.

(Measurement of hardness and elastic modulus recovery ratio)

Measurements were carried out on underlying layers of the above prepared substrates 1 to 6 according to the nanoindentation method described above. A sample for measuring physical properties was measured in a stage in which an underlying layer is in the top layer. Specifically, the sample was measured with a sample size of 2 cm × 2 cm, under an environment at 23°C, 55%RH with a nanoindenter (Nano Indenter TMXP/DCM) manufactured by MTS Systems Corporation. Numerical values of the hardness and the elastic modulus recovery ratio were obtained by finding a mean value of numerical values of 5 points measured in the 2 cm × 2 cm sample and determined to be the hardness and the elastic modulus recovery ratio of the layer.

(Evaluation of water vapor transmission ratio)

A water vapor transmission ratio was evaluated by the following method.

<Device>

Deposition apparatus: Vacuum deposition apparatus JEE-400 manufactured by JEOL Ltd.
Constant temperature and humidity oven: Yamato Humidic Chamber IG47M
Laser microscope: KEYENCE VK-8500

<Raw materials>

Metal corroded by reaction with moisture: calcium (granulated)

Water vapor impermeable metal: aluminum (ϕ3 to 5 mm, granulated)

<Preparation of cell for evaluation of water vapor barrier performance>

Metal calciumwas deposited on a gas barrier layer surface of a gas barrier film in an area of 1 cm × 1 cm with a mask using a vacuum deposition apparatus (deposition apparatus JEE-400 manufactured by JEOL Ltd.) Then, the mask was removed with keeping a vacuum state, and aluminum was deposited on the whole surface of one side of the sheet from the other metal deposition source. After sealing with aluminum, the vacuum state was released and a quartz glass with a thickness of 0.2 mm was rapidly faced with the aluminum sealing side through a sealing ultraviolet ray curable resin (manufactured by Nagase Chemtex Corporation) under a dry nitrogen gas atmosphere and irradiated with an ultraviolet ray to thus prepare a cell for evaluation.

The obtained sample having the both surfaces sealed was preserved under a high temperature and a high humidity of 60°C and 90%RH, and a moisture content that permeated into a cell was calculated from a corrosion amount of metal calcium 1% and 50% based on the method described in Japanese Patent Laid-Open No. 2005-283561 to calculate a water vapor transmission ratio (WVTR).

In addition, in order to confirm no permeation of water vapor other than water vapor from a barrier film surface, a sample to which metal calcium was deposited using a 0.2 mm-quartz glass plate was preserved under a high temperature and a high humidity at 60°C, 90%RH in the same manner in place of a barrier film sample as a comparative sample and

it was confirmed that metal calcium corrosion did not occur even after elapse of the time for 1,000 hours.

Results of the measurement and evaluation are shown in Tables 1 and 2.

[Table 1]

| *1 | Underlying layer | | | Gas barrier layer | | Moisture transmission ratio evaluation 60°C 90% RH | | Remarks |
|---|---|---|---|---|---|---|---|---|
| | Materials | Hardness (GPa) | Elastic recovery ratio (%) | Materials | Production method | WVTR (1% corrosion) [$g/m^2 \cdot day$] | WVTR (50% corrosion) [$g/m^2 \cdot day$] | |
| 1-1 | UV curable acrylic resin (Z7501) | 0.4 | 48.1 | $SiO_2$ | Atmospheric pressure PECVD | $1\times10^{-2}$ | $7\times10^{-2}$ | Comparative Example |
| 1-2 | UV curable acrylic resin/VUV treated titanium oligomer (PC685) | 2.3 | 46.1 | $SiO_2$ | Atmospheric pressure PECVD | $5\times10^{-2}$ (Cracks) | - | Comparative Example |
| 1-3 | Polysiloxane/acrylic resin hybrid (Glassca HPC7506) | 0.25 | 51.2 | $SiO_2$ | Atmospheric pressure PECVD | $<5\times10^{-2}$ (Cracks) | - | Comparative Example |
| 1-4 | VUV treated polysiloxane (Glassca HPC7003) | 1.2 | 84.7 | $SiO_2$ | Atmospheric pressure PECVD | $1\times10^{-3}$ | $2\times10^{-2}$ | The invention |
| 1-5 | UV curable acrylic resin/polysilazane (NAX120) | 2.4 | 83.5 | $SiO_2$ | Atmospheric pressure PECVD | $1\times10^{-3}$ | $1\times10^{-2}$ | The invention |
| 1-6 | Organic inorganic nanocomposite (SSG-HB21B) | 0.9 | 62.6 | $SiO_2$ | Atmospheric pressure PECVD | $3\times10^{-3}$ | $5\times10^{-2}$ | The invention |
| 1-7 | UV curable acrylic resin (Z7501) | 0.4 | 48.1 | Polysilazane | Coating/VUV modification | $1\times10^{-2}$ | $2\times10^{-2}$ | Comparative Example |
| 1-8 | UV curable acrylic resin/VUV treated titanium oligomer (PC685) | 2.3 | 46.1 | Polysilazane | Coating/VUV modification | $5\times10^{-2}$ (Cracks) | - | Comparative Example |
| 1-9 | Polysiloxane/acrylic resin hybrid (Glassca HPC7506) | 0.25 | 51.2 | Polysilazane | Coating/VUV modification | Cracks in film formation | - | Comparative Example |

*1: Gas barrier film No.

[Table 2]

| *1 | Underlying layer | | | Gas barrier layer | | Moisture transmission ratio evaluation 60°C 90% RH | | Remarks |
|---|---|---|---|---|---|---|---|---|
| | Materials | Hardness (GPa) | Elastic recovery ratio (%) | Materials | Production method | WVTR (1% corrosion) [$g/m^2 \cdot day$] | WVTR (50% corrosion) [$g/m^2 \cdot day$] | |
| 1-10 | VUV treated polysiloxane (Glassca HPC7003) | 1.2 | 84.7 | Polysilazane | Coating/VUV conversion | $1\times10^{-3}$ | $5\times10^{-2}$ | The invention |
| 1-11 | UV curable acrylic resin/polysilazane (NAX120) | 2.4 | 83.5 | Polysilazane | Coating/VUV conversion | $1\times10^{-3}$ | $2\times10^{-2}$ | The invention |
| 1-12 | Organic inorganic nanocomposite (SSG-HB21B) | 0.9 | 62.6 | Polysilazane | Coating/VUV conversion | $4\times10^{-3}$ | $8\times10^{-2}$ | The invention |
| 1-13 | UV curable acrylic resin (Z7501) | 0.4 | 48.1 | Ga nitrate | Coating/VUV conversion | $5\times10^{-2}$ | $3\times10^{-1}$ | Comparative Example |
| 1-14 | UV curable acrylic resin/VUV treated titanium oligomer (PC685) | 2.3 | 46.1 | Ga nitrate | Coating/VUV conversion | Cracks in film formation | - | Comparative Example |
| 1-15 | Polysiloxane/acrylic resin hybrid (Glassca HPC7506) | 0.25 | 51.2 | Ga nitrate | Coating/VUV conversion | Cracks in film formation | - | Comparative Example |
| 1-16 | VUV treated polysiloxane (Glassca HPC7003) | 1.2 | 84.7 | Ga nitrate | Coating/VUV conversion | $4\times10^{-3}$ | $7\times10^{-2}$ | The invention |
| 1-17 | UV curable acrylic resin/polysilazane (NAX120) | 2.4 | 83.5 | Ga nitrate | Coating/VUV conversion | $2\times10^{-3}$ | $6\times10^{-2}$ | The invention |
| 1-18 | Organic inorganic nanocomposite (SSG-HB21B) | 0.9 | 62.6 | Ga nitrate | Coating/VUV conversion | $5\times10^{-3}$ | $8\times10^{-2}$ | The invention |

*1: Gas barrier film No.

**[0203]** It was found that in the gas barrier layer using an underlying layer according to the present invention, a water vapor transmission ratio [g/($m^2$·24 h)] calculated from 1% and 5% corrosion of Ca can be suppressed to be low and gas barrier performance is significantly improved. In addition, gas barrier performance can be improved without depending on a film formation method and materials of an underlying layer, and a gas barrier layer formed by coating has a large improvement range.

Furthermore, all gas barrier layers had cracks generated after film format ion in the gas barrier film using the substrate 2, and it is found that high gas barrier performance cannot be attained only by a high hardness.

Example 2 (Protecting layer physical properties and gas barrier performance)

<Preparation of gas barrier films>

<Preparation of gas barrier films 2-1 to 2-6>

Six gas barrier films using atmospheric pressure plasma CVD films as gas barrier layers were prepared in the same manner as formation of the gas barrier layers of the gas barrier films 1-1 to 1-6 of Example 1 using the substrate 1 prepared in Example 1, and a film made of materials used in the underlying layers of the substrates 1 to 6 and treated in Example 1 was formed with a total film thickness of 500 nm on the gas barrier layers to thus obtain gas barrier films 2-1 to 2-6 as protecting layers. Note that a film thickness of a UV curable acrylic resin film in each of 2-2 and 2-5 is 350 nm.

<Preparation of gas barrier films 2-7 to 2-12>

Six gas barrier films having excimer light converted films made of polysilazane as gas barrier layers were prepared in the same manner as in formation of the gas barrier layers of the gas barrier films 1-7 to 1-12 in Example 1 using the substrate 1 prepared in Example 1, and a film made of materials used in the underlying layer of the substrates 1 to 6 and treated in Example 1 was formed with a total film thickness of 500 nm on the gas barrier layers to thus obtain gas barrier films 2-7 to 2-14 as protecting layers. Note that a film thickness of a UV acrylic curable resin film in each of 2-8 and 2-11 is 350 nm.

<Preparation of gas barrier films 2-13 to 2-18>

Six gas barrier films having excimer light converted films made of Ga nitrate as gas barrier layers were prepared in the same manner as in formation of the gas barrier layers of the gas barrier films 1-13 to 1-18 in Example 1 using the substrate 1 prepared in Example 1, and a film made of materials used in the underlying layers of the substrates 1 to 6 and treated in Example 1 was formed with a total film thickness of 500 nm on the gas barrier layers to thus obtain gas barrier films 2-13 to 2-18 as protecting layers. Note that a film thickness of a UV curable acrylic resin film in each of 2-14 and 2-17 is 350 nm.

<Evaluation of gas barrier films>

Hardness and elastic modulus recovery ratios of the protecting layers and water vapor transmission ratios of the gas barrier films were evaluated on the prepared gas barrier films in the same manner as in Example 1. A method for preparing samples for measuring hardness and elastic modulus recovery ratios of the protecting layers and methods for measuring the hardness and the elastic modulus recovery ratios were the same as described in the section of the underlying layer.

Results of the measurement and evaluation are shown in Tables 3 and 4.

[Table 3]

| *1 | Protecting layer | | | Gas barrier layer | | Moisture transmission ratio evaluation 60°C 90%RH | | Remarks |
|---|---|---|---|---|---|---|---|---|
| | Materials | Hardness (GPa) | Elastic recovery ratio (%) | Materials | Production method | WVTR (1% corrosion) [$g/m^2 \cdot day$] | WVTR (50% corrosion) [$g/m^2 \cdot day$] | |
| 2-1 | UV curable acrylic resin (Z7501) | 0.4 | 48.1 | $SiO_2$ | Atmospheric pressure PECVD | $1\times10^{-2}$ | $4\times10^{-2}$ | Comparative Example |
| 2-2 | UV curable acrylic resin/VUV treated titanium oligomer (PC685) | 2.3 | 46.1 | $SiO_2$ | Atmospheric pressure PECVD | $1\times10^{-2}$ | $5\times10^{-2}$ | Comparative Example |
| 2-3 | Polysiloxane/acrylic resin hybrid (Glassca HPC7506) | 0.25 | 51.2 | $SiO_2$ | Atmospheric pressure PECVD | $1\times10^{-2}$ | $9\times10^{-2}$ | Comparative Example |
| 2-4 | VUV treated polysiloxane (Glassca HPC7003) | 1.2 | 84.7 | $SiO_2$ | Atmospheric pressure PECVD | $9\times10^{-3}$ | $9\times10^{-3}$ | The invention |
| 2-5 | UV curable acrylic resin/polysilazane (NAX120) | 2.4 | 83.5 | $SiO_2$ | Atmospheric pressure PECVD | $9\times10^{-3}$ | $9\times10^{-3}$ | The invention |
| 2-6 | Organic inorganic nanocomposite (SSG-HB21B) | 0.9 | 62.6 | $SiO_2$ | Atmospheric pressure PECVD | $9\times10^{-3}$ | $1\times10^{-2}$ | The invention |
| 2-7 | UV curable acrylic resin (Z7501) | 0.4 | 48.1 | Polysilazane | Coating/VUV conversion | $1\times10^{-2}$ | $9\times10^{-2}$ | Comparative Example |
| 2-8 | UV curable acrylic resin/VUV treated titanium oligomer (PC685) | 2.3 | 46.1 | Polysilazane | Coating/VUV conversion | $1\times10^{-2}$ | $5\times10^{-2}$ | Comparative Example |
| 2-9 | Polysiloxane/acrylic resin hybrid (Glassca HPC7506) | 0.25 | 51.2 | Polysilazane | Coating/VUV conversion | $1\times10^{-2}$ | $8\times10^{-2}$ | Comparative Example |

*1: Gas barrier film No.

[Table 4]

| *1 | Protecting layer | | | Gas barrier layer | | Moisture transmission ratio evaluation 60°C 90%RH | | Remarks |
|---|---|---|---|---|---|---|---|---|
| | Materials | Hardness (GPa) | Elastic recovery ratio (%) | Materials | Production method | WVTR (1% corrosion) [g/$m^2$·day] | WVTR (50% corrosion) [g/$m^2$·day] | |
| 2-10 | VUV treated polysiloxane (Glass HPC7003) | 1.2 | 84.7 | Polysilazane | Coating/VUV conversion | $1\times10^{-2}$ | $1\times10^{-2}$ | The invention |
| 2-11 | UV curable acrylic resin/polysilazane (NAX120) | 2.4 | 83.5 | Polysilazane | Coating/VUV conversion | $1\times10^{-2}$ | $1\times10^{-2}$ | The invention |
| 2-12 | Organic inorganic nanocomposite (SSG-HB21B) | 0.9 | 62.6 | Polysilazane | Coating/VUV conversion | $1\times10^{-2}$ | $2\times10^{-2}$ | The invention |
| 2-13 | UV curable acrylic resin (Z7501) | 0.4 | 48.1 | Ga nitrate | Coating/VUV conversion | $5\times10^{-2}$ | $1\times10^{-1}$ | Comparative Example |
| 2-14 | UV curable acrylic resin/VUV treated titanium oligomer (PC685) | 2.3 | 46.1 | Ga nitrate | Coating/VUV conversion | $5\times10^{-2}$ | $9\times10^{-2}$ | Comparative Example |
| 2-15 | Polysiloxane/acrylic resin hybrid (Glassca HPC7506) | 0.25 | 51.2 | Ga nitrate | Coating/VUV conversion | $5\times10^{-2}$ | $1\times10^{-2}$ | Comparative Example |
| 2-16 | VUV treated polysiloxane (Glass HPC7003) | 1.2 | 84.7 | Ga nitrate | Coating/VUV conversion | $5\times10^{-2}$ | $5\times10^{-2}$ | The invention |
| 2-17 | UV curable acrylic resin/polysilazane (NAX120) | 2.4 | 83.5 | Ga nitrate | Coating/VUV conversion | $4\times10^{-2}$ | $5\times10^{-2}$ | The invention |
| 2-18 | Organic inorganic nanocomposite (SSG-HB21B) | 0.9 | 62.6 | Ga nitrate | Coating/VUV conversion | $5\times10^{-2}$ | $5\times10^{-2}$ | The invention |

*1: Gas barrier film No.

**[0210]** It was found from the tables that the gas barrier film using a protecting layer according to the present invention has extremely small change in gas barrier performance even after progress of Ca corrosion, that is, after exposing under a high temperature and a high humidity for a long time in a state of a sealed cell and receiving stress for a long time. It is also found that the gas barrier performance can be maintained without depending on a film formation method and materials of the protecting layer.

Example 3 (Combination of underlying layer and protecting layer and gas barrier performance)

<Preparation of gas barrier films>

<Preparation of gas barrier films 3-1 to 3-18>

A gas barrier film having a structure of combining the underlying layer of Example 1 and the protecting layer of Example 2 was prepared. An underlying layer material and a protecting layer material were combined to be identical. Specific materials were described in Tables 5 and 6. A gas barrier layer was prepared in the same manner as in Example 1 and materials used in each film and a production method were described in Tables 5 and 6.

<Evaluation of gas barrier films>

Hardness and elastic modulus recovery ratios of the underlying layers and the protecting layers and water vapor transmission ratios of the gas barrier films were evaluated on the prepared gas barrier films in the same manner as in Example 1. Note that for the standards using the substrate 2 and substrate 3, evaluations of water vapor transmission ratios were not performed since cracks were generated in the same manner as in Example 1.
Results of the measurement and evaluation are shown in Tables 5 and 6.

[Table 5]

| *1 | Underlying layer and protecting layer | | | Gas barrier layer | | Moisture transmission ratio evaluation60° C90%RH | | Remarks |
|---|---|---|---|---|---|---|---|---|
| | Materials | Hardness (GPa) | Elastic recovery ratio (%) | Materials | Production method | WVTR (1% corrosion) [$g/m^2 \cdot day$] | WVTR (50% corrosion) [$g/m^2 \cdot day$] | |
| 3-1 | UV curable acrylic resin (Z7501) | 0.4 | 48.1 | $SiO_2$ | Atmospheric pressure PECVD | $1 \times 10^{-2}$ | $4 \times 10^{-2}$ | Comparative Example |
| 3-2 | UV curable acrylic resin/VUV treated titanium oligomer (PC685) | 2.3 | 46.1 | $SiO_2$ | Atmospheric pressure PECVD | - | - | Comparative Example |
| 3-3 | Polysiloxane/acrylic resin hybrid (Glassca HPC7506) | 0.25 | 51.2 | $SiO_2$ | Atmospheric pressure PECVD | - | - | Comparative Example |
| 3-4 | VUV treated polysiloxane (Glassca HPC7003) | 1.2 | 84.7 | $SiO_2$ | Atmospheric pressure PECVD | $1 \times 10^{-3}$ | $1 \times 10^{-3}$ | The invention |
| 3-5 | UV curable acrylic resin/polysilazane (NAX120) | 2.4 | 83.5 | $SiO_2$ | Atmospheric pressure PECVD | $1 \times 10^{-3}$ | $1 \times 10^{-3}$ | The invention |
| 3-6 | Organic inorganic nanocomposite (SSG-HB21B) | 0.9 | 62.6 | $SiO_2$ | Atmospheric pressure PECVD | $3 \times 10^{-3}$ | $3 \times 10^{-3}$ | The invention |
| 3-7 | UV curable acrylic resin (Z7501) | 0.4 | 48.1 | Polysilazane | Coating/VUV conversion | $1 \times 10^{-2}$ | $9 \times 10^{-2}$ | Comparative Example |
| 3-8 | UV curable acrylic resin/VUV treated titanium oligomer (PC685) | 2.3 | 46.1 | Polysilazane | Coating/VUV conversion | - | - | Comparative Example |
| 3-9 | Polysiloxane/acrylic resin hybrid (Glassca HPC7506) | 0.25 | 51.2 | Polysilazane | Coating/VUV conversion | - | - | Comparative Example |

*1: Gas barrier film No.

[Table 6]

| *1 | Underlying layer and protecting layer | | | Gas barrier layer | | Moisture transmission ratio evaluation 60°C 90%RH | | Remarks |
|---|---|---|---|---|---|---|---|---|
| | Materials | Hardness (GPa) | Elastic recovery ratio (%) | Materials | Production method | WVTR (1% corrosion) [g/$m^2$·day] | WVTR (50% corrosion) [g/$m^2$·day] | |
| 3-10 | VUV treated polysiloxane (Glassca HPC7003) | 1.2 | 84.7 | Polysilazane | Coating/VUV conversion | $3\times10^{-3}$ | $3\times10^{-3}$ | The invention |
| 3-11 | UV curable acrylic resin/polysilazane (NAX120) | 2.4 | 83.5 | Polysilazane | Coating/VUV conversion | $1\times10^{-3}$ | $1\times10^{-3}$ | The invention |
| 3-12 | Organic inorganic nanocomposite (SSG-HB21B) | 0.9 | 62.6 | Polysilazane | Coating/VUV conversion | $4\times10^{-2}$ | $4\times10^{-3}$ | The invention |
| 3-13 | UV curable acrylic resin (Z7501) | 0.4 | 48.1 | Ga nitrate | Coating/VUV conversion | $5\times10^{-2}$ | $9\times10^{-2}$ | Comparative Example |
| 3-14 | UV curable acrylic resin/VUV treated titanium oligomer (PC685) | 2.3 | 46.1 | Ga nitrate | Coating/VUV conversion | - | - | Comparative Example |
| 3-15 | Polysiloxane/acrylic resin hybrid (Glassca HPC7506) | 0.25 | 51.2 | Ga nitrate | Coating/VUV conversion | - | - | Comparative Example |
| 3-16 | VUV treated polysiloxane (Glassca HPC7003) | 1.2 | 84.7 | Ga nitrate | Coating/VUV conversion | $4\times10^{-3}$ | $4\times10^{-3}$ | The invention |
| 3-17 | UV curable acrylic resin/polysilazane (NAX120) | 2.4 | 83.5 | Ga nitrate | Coating/VUV conversion | $2\times10^{-3}$ | $2\times10^{-3}$ | The invention |
| 3-18 | Organic inorganic nanocomposite (SSG-HB21B) | 0.9 | 62.6 | Ga nitrate | Coating/VUV conversion | $5\times10^{-3}$ | $5\times10^{-3}$ | The invention |

*1: Gas barrier film No.

**[0214]** It was found from tables that the gas barrier film using an underlying layer and a protecting layer according to the present invention can be improved in the initial gas barrier performance and keep the performance for a long time. It is also found that the gas barrier performance can be improved and maintained without depending on a film formation method and materials of the underlying layer and the protecting layer.

REFERENCE SIGNS LIST

1 Initial surface of a sample at the time of not contacting with a penetrator
2 Profile of a sample surface at the time of charging a load through a penetrator
3 Profile of a sample surface after removing a penetrator W Load

## Claims

1. A gas barrier film, which is obtained by laminating at least one gas barrier layer on a resin substrate, wherein a hardness and an elastic modulus recovery ratio of at least one layer that is adjacent to the gas barrier layer satisfy 0.5 GPa ≤ hardness ≤ 5.0 GPa and 50% ≤ elastic modulus recovery ratio ≤ 100% as measured by a nanoindentation method.

2. The gas barrier film according to claim 1, wherein a hardness and an elastic modulus recovery ratio of at least one layer that is adjacent to the gas barrier layer satisfy 0.7 GPa ≤ hardness ≤ 2.0 GPa and 60% ≤ elastic modulus recovery ratio ≤ 90% as measured by a nanoindentation method.

3. The gas barrier film according to claim 1 or 2, wherein the gas barrier layer comprises a metal oxide, a metal nitride, or a metal oxynitride.

4. The gas barrier film according to claim 3, wherein a metal in the metal oxide, metal nitride, or metal oxynitride comprises at least one metal selected from the group consisting of Si, Al, and Ga.

5. A method for producing the gas barrier film according to any one of claims 1 to 4, wherein the gas barrier layer or at least one layer that is adjacent to the gas barrier layer is formed by performing conversion treatment to a precursor layer formed by coating.

## Patentansprüche

1. Gasbarrierefilm, der durch Laminieren mindestens einer Gasbarriereschicht auf ein Harzsubstrat erhalten wird, wobei eine Härte und ein Elastizitätsmodulwiederherstellungsverhältnis von mindestens einer Schicht, die an die Gasbarriereschicht angrenzt, 0,5 GPa ≤ Härte ≤ 5,0 GPa und 50 % ≤ Elastizitätsmodulwiederherstellungsverhältnis ≤ 100 % entsprechen, wie durch ein Nanoindentierungsverfahren gemessen.

2. Gasbarrierefilm nach Anspruch 1, wobei eine Härte und ein Elastizitätsmodulwiederherstellungsverhältnis von mindestens einer Schicht, die an die Gasbarriereschicht angrenzt, 0,7 GPa ≤ Härte ≤ 2,0 GPa und 60 % ≤ Elastizitätsmodulwiederherstellungsverhältnis ≤ 90 % entsprechen, wie durch ein Nanoindentierungsverfahren gemessen.

3. Gasbarrierefilm nach Anspruch 1 oder 2, wobei die Gasbarriereschicht ein Metalloxid, ein Metallnitrid oder ein Metalloxynitrid umfasst.

4. Gasbarrierefilm nach Anspruch 3, wobei ein Metall in dem Metalloxid, dem Metallnitrid oder dem Metalloxynitrid mindestens ein Metall umfasst, das aus der Gruppe bestehend aus Si, Al und Ga ausgewählt ist.

5. Verfahren zur Produktion des Gasbarrierefilms nach einem der Ansprüche 1 bis 4, wobei die Gasbarriereschicht oder die mindestens eine Schicht, die an die Gasbarriereschicht angrenzt, durch Durchführen einer Konversionsbehandlung in eine durch Beschichten gebildete Vorläuferschicht gebildet wird.

**Revendications**

1. Film barrière aux gaz, qui est obtenu par stratification d'au moins une couche barrière aux gaz sur un substrat en résine, dans lequel une dureté et un taux de récupération de module d'élasticité d'au moins une couche qui est adjacente à la couche barrière aux gaz, tels que mesurés par une méthode de nanopénétration, satisfont à 0,5 GPa ≤ dureté ≤ 5,0 GPa et 50 % ≤ taux de récupération de module d'élasticité ≤ 100 %.

2. Film barrière aux gaz selon la revendication 1, dans lequel une dureté et un taux de récupération de module d'élasticité d'au moins une couche qui est adjacente à la couche barrière aux gaz, tels que mesurés par une méthode de nanopénétration, satisfont à 0,7 GPa ≤ dureté ≤ 2,0 GPa et 60 % ≤ taux de récupération de module d'élasticité ≤ 90 %.

3. Film barrière aux gaz selon la revendication 1 ou 2, dans lequel la couche barrière aux gaz comprend un oxyde métallique, un nitrure métallique ou un oxynitrure métallique.

4. Film barrière aux gaz selon la revendication 3, dans lequel un métal dans l'oxyde métallique, le nitrure métallique ou l'oxynitrure métallique comprend au moins un métal choisi dans le groupe constitué par Si, Al et Ga.

5. Procédé pour la production du film barrière aux gaz selon l'une quelconque des revendications 1 à 4, dans lequel la couche barrière aux gaz ou au moins une couche qui est adjacente à la couche barrière aux gaz est formée par la mise en oeuvre d'un traitement de conversion sur une couche de précurseur formée par enduction.

FIG.1

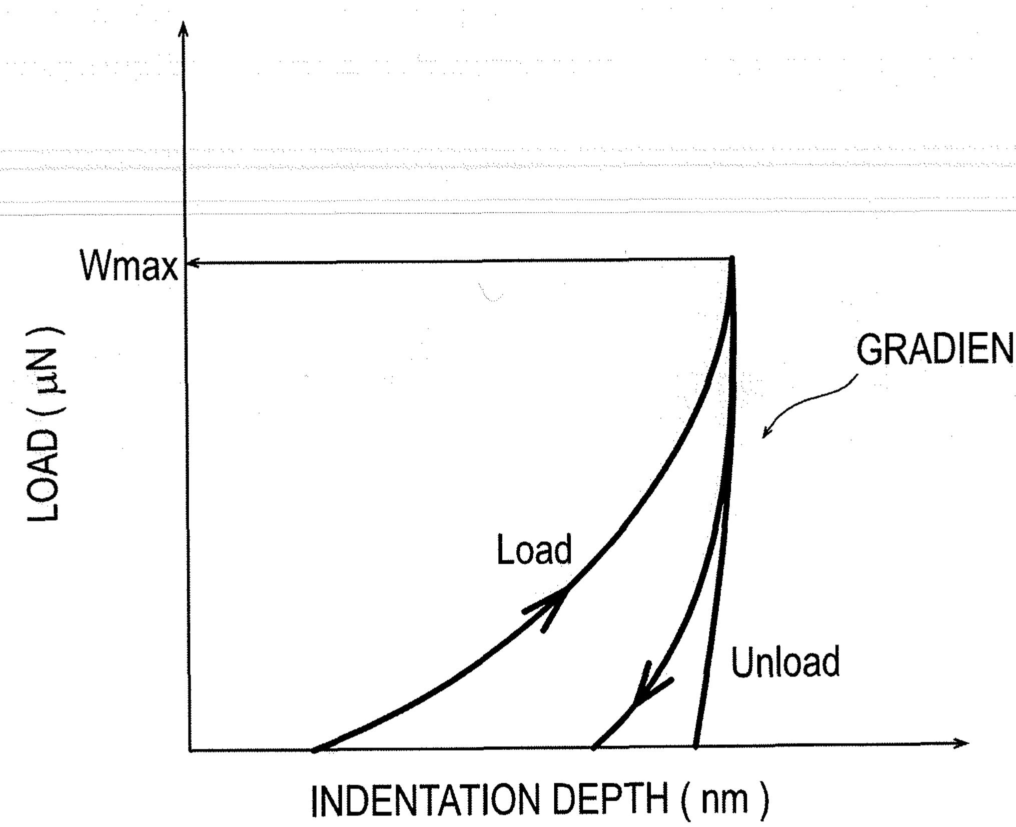
Wmax
LOAD ( μN )
GRADIENT s
Load
Unload
INDENTATION DEPTH ( nm )

FIG.2

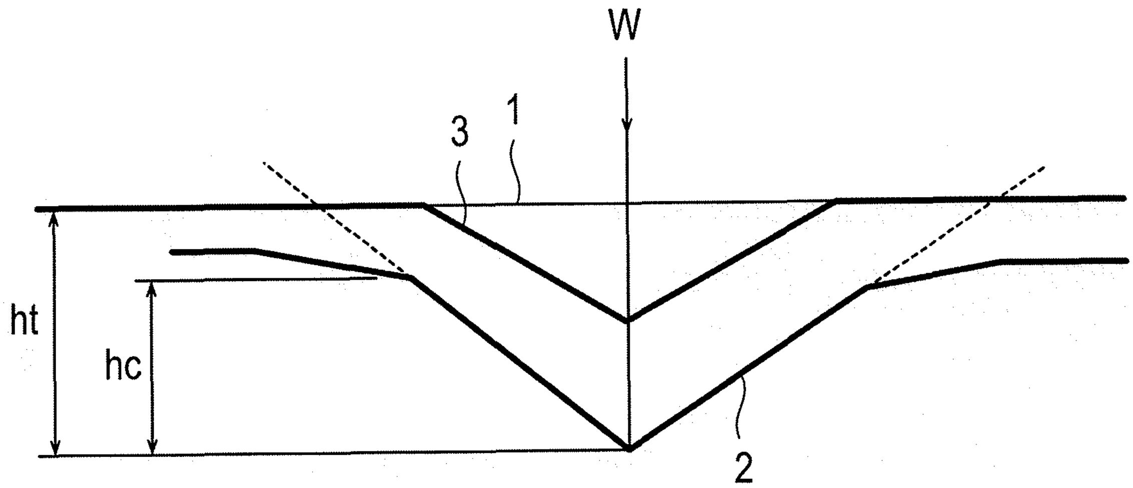
W
3
1
ht
hc
2

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2008056967 A
- JP 2009255040 A
- US 2010166977 A
- US 2010003482 A
- US 2011064947 A
- JP 11158608 A
- WO 2008096617 A1
- JP 5238827 A
- JP 6122852 A
- JP 6240208 A
- JP 6299118 A
- JP 6306329 A
- JP 7196986 A
- JP 10154598 A
- JP 2003049272 A
- WO 02048428 A
- JP 2004068143 A
- JP 11016696 A
- JP 2005283561 A